# EUROPEAN PATENT APPLICATION

(11) **EP 4 261 873 A2**
(43) Date of publication of application: **18.10.2023**
(21) Application number: 23165158.9
(22) Date of filing: 29.03.2023
(51) Int. Cl.: H01L 21/822, H01L 21/8234, H01L 27/06, H01L 27/092, H01L 29/06, H01L 29/66, H01L 29/775, H01L 29/786

(54) **SEMICONDUCTOR DEVICE**

(30) Priority: 12.04.2022 KR 20220045293
(71) Applicant: Samsung Electronics Co., Ltd., Suwon-si, Gyeonggi-do 16677 (KR)
(72) Inventor: HWANG, Kyu Man, 16677 Suwon-si (KR); PARK, Sung Il, 16677 Suwon-si (KR); PARK, Jae Hyun, 16677 Suwon-si (KR); CHOI, Do Young, 16677 Suwon-si (KR)
(74) Representative: Marks & Clerk LLP

(57) **Abstract**

A semiconductor device including a lower pattern extending in a first direction, a gate electrode on the lower pattern and extending in a second direction, a lower channel pattern on the lower pattern and comprising at least one lower sheet pattern, an upper channel pattern on the lower channel pattern and comprising at least one upper sheet pattern, , wherein the upper channel pattern is spaced apart from the lower channel pattern in a third direction, the gate electrode comprises a lower gate electrode through which the lower sheet pattern passes and an upper gate electrode through which the upper sheet pattern passes, the lower gate electrode comprises a lower conductive liner layer defining a trench and a lower filling layer filling the trench, and an entire bottom surface of the upper gate electrode is higher than an upper surface of the lower gate electrode, may be provided.

## Description

### BACKGROUND

### 1. Technical Field

The present disclosure relates to semiconductor devices.

### 2. Description of the Related Art

As one of scaling techniques for increasing the density of semiconductor devices, a multi-gate transistor has been proposed, in which a fin- or nanowire-shaped multi-channel active pattern (or silicon body) is formed on a substrate and a gate is formed on the surface of the multi-channel active pattern.

Because the multi-gate transistor uses a three-dimensional (3D) channel, scaling of the multi-gate transistor can be easily achieved. Further, current control capability can be improved without increasing the gate length of the multi-gate transistor. In addition, a short channel effect (SCE) in which the potential of a channel region is affected by a drain voltage can be effectively suppressed.

### SUMMARY

Some aspects of the present disclosure provide semiconductor devices capable of improving element performance and reliability.

However, aspects of the present disclosure are not restricted to the ones set forth herein. The above and other aspects of the present disclosure will become more apparent to one of ordinary skill in the art to which the present disclosure pertains by referring to the detailed description of the present disclosure given below.

According to an aspect of the present disclosure, a semiconductor device includes a lower pattern extending in a first direction, a gate electrode on the lower pattern and extending in a second direction, a lower channel pattern on the lower pattern and comprising at least one lower sheet pattern, an upper channel pattern on the lower channel pattern and comprising at least one upper sheet pattern, wherein the upper channel pattern is spaced apart from the lower channel pattern in a third direction, the gate electrode comprises a lower gate electrode through which the lower sheet pattern passes, and an upper gate electrode through which the upper sheet pattern passes, the lower gate electrode comprises a lower conductive liner layer defining a lower liner trench and a lower filling layer filling the lower liner trench, and an entire bottom surface of the upper gate electrode is higher than an upper surface of the lower gate electrode.

According to another aspect of the present disclosure, a semiconductor device comprising a first lower pattern extending in a first direction, a second lower pattern extending in the first direction, a first gate electrode on the first lower pattern and extending in a second direction, a second gate electrode on the second lower pattern and extending in the second direction, a first lower channel pattern on the first lower pattern and comprising at least one first lower sheet pattern, a first upper channel pattern on the first lower channel pattern and comprising at least one first upper sheet pattern, a second lower channel pattern on the second lower pattern and comprising at least one second lower sheet pattern, a second upper channel pattern on the second lower channel pattern and comprising at least one second upper sheet pattern, a first gate insulating layer between the first lower sheet pattern and the first gate electrode and between the first upper sheet pattern and the first gate electrode and a second gate insulating layer between the second lower sheet pattern and the second gate electrode and between the second upper sheet pattern and the second gate electrode, wherein the first gate electrode comprises a first lower gate electrode through which the first lower sheet pattern passes, a first upper gate electrode through which the first upper sheet pattern passes, and a first insertion pattern between the first lower gate electrode and the first upper gate electrode, the second gate electrode comprises a second lower gate electrode through which the second lower sheet pattern passes, a second upper gate electrode through which the second upper sheet pattern passes, and a second insertion pattern between the second lower gate electrode and the second upper gate electrode, the first insertion pattern is between an upper surface of the first lower channel pattern and a bottom surface of the first upper channel pattern, the second insertion pattern is between an upper surface of the second lower channel pattern and a bottom surface of the second upper channel pattern, and the first insertion pattern includes a same material as the second insertion pattern.

According to still another aspect of the present disclosure, a semiconductor device includes a first lower pattern extending in a first direction, a second lower pattern extending in the first direction, a first gate electrode on the first lower pattern and extending in a second direction, a second gate electrode on the second lower pattern and extending in the second direction, a first lower channel pattern on the first lower pattern and comprising at least one first lower sheet pattern, a first upper channel pattern on the first lower channel pattern and comprising at least one first upper sheet pattern, a second lower channel pattern on the second lower pattern and comprising at least one second lower sheet pattern, a second upper channel pattern on the second lower channel pattern and comprising at least one second upper sheet pattern, a first gate insulating layer between the first lower sheet pattern and the first gate electrode and between the first upper sheet pattern and the first gate electrode and a second gate insulating layer between the second lower sheet pattern and the second gate electrode and between the second upper sheet pattern and the second gate electrode, wherein the first gate electrode comprises a first lower gate electrode through which the first lower sheet pattern passes, and a first upper gate electrode through which the first upper sheet pattern passes, the second gate electrode comprises a second lower gate electrode through which the second lower sheet pattern passes, and a second upper gate electrode through which the second upper sheet pattern passes, the first lower gate electrode comprises a first lower conductive liner layer defining a first lower liner trench and a first lower filling layer filling the first lower liner trench, the second lower gate electrode comprises a second lower conductive liner layer defining a second lower liner trench and a second lower filling layer filling the second lower liner trench, an entire bottom surface of the first upper gate electrode is between an upper surface of the first lower channel pattern and a bottom surface of the first upper channel pattern, an entire bottom surface of the second upper gate electrode is between an upper surface of the second lower channel pattern and a bottom surface of the second upper channel pattern, the first lower conductive liner layer includes a same material as the second lower conductive liner layer, the first gate insulating layer includes a same material as the second gate insulating layer, and the first gate insulating layer surrounding the first lower sheet pattern includes a first lower doping material, and the second gate insulating layer surrounding the second lower sheet pattern includes a second lower doping material different from the first lower doping material.

According to still another aspect of the present disclosure, a method of fabricating a semiconductor device includes forming a gate spacer defining a gate trench on a lower pattern extending in a first direction, forming a lower channel pattern and an upper channel pattern exposed by the gate trench, on the lower pattern, forming a lower conductive liner layer surrounding the lower channel pattern and defining a lower liner trench, an uppermost portion of the lower conductive liner layer being lower than a bottom surface of the upper channel pattern, forming a lower filling layer filling the lower liner trench, on the lower conductive liner layer such that an entire upper surface of the lower filling layer is disposed between an upper surface of the lower channel pattern and a bottom surface of the upper channel pattern, forming an insertion pattern on the lower filling layer; and forming an upper gate electrode on the insertion pattern.

At least some of the above and other features of the invention are set out in the claims.

### BRIEF DESCRIPTION OF THE DRAWINGS

The above and other aspects and features of the present disclosure will become more apparent by describing in detail some example embodiments thereof with reference to the attached drawings, in which:
FIG. 1 is a layout diagram illustrating a semiconductor device according to an example embodiment;
FIG. 2 shows cross-sectional views taken along lines A-A, B-B and C-C of FIG. 1;
FIG. 3 shows cross-sectional views taken along lines D-D, E-E and F-F of FIG. 1;
FIGS. 4 and 5 are enlarged views illustrating part P of FIG. 2;
FIGS. 6 and 7 are diagrams illustrating a semiconductor device according to an example embodiment;
FIGS. 8 to 10 are diagrams illustrating a semiconductor device according to an example embodiment;
FIGS. 11 to 13 are diagrams illustrating a semiconductor device according to an example embodiment;
FIGS. 14 and 15 are diagrams illustrating a semiconductor device according to an example embodiment;
FIGS. 16 and 17 are diagrams illustrating a semiconductor device according to an example embodiment;
FIGS. 18 and 19 are diagrams illustrating a semiconductor device according to an example embodiment;
FIGS. 20 and 21 are diagrams illustrating a semiconductor device according to an example embodiment;
FIGS. 22 and 23 are diagrams illustrating a semiconductor device according to an example embodiment;
FIGS. 24 to 27 are diagrams each illustrating a semiconductor device according to some example embodiments; and
FIGS. 28 to 46 are views illustrating the intermediate steps of a method of fabricating a semiconductor device according to an example embodiment.

### DETAILED DESCRIPTION

In the drawings of semiconductor devices according to some example embodiments, a multi-bridge channel field effect transistor (MBCFET^{™}), a transistor including a nanowire or a nanosheet, is illustrated as an example, but the present disclosure is not limited thereto. It is obvious that the semiconductor device according to some example embodiments may include a fin-type transistor (FinFET) including a channel region having a fin shape, a tunneling transistor (tunneling FET), or a three-dimensional (3D) transistor. It goes without saying that semiconductor devices according to some example embodiments may include a planar transistor. In addition, the present disclosure can be applied to transistors based on two-dimensional materials (2D material-based FETs) and heterostructures thereof.

Further, semiconductor devices according to some example embodiments may include a bipolar junction transistor, a lateral double diffusion MOS (LDMOS) transistor, or the like.

As used herein, expressions such as "one of" and "at least one of," when preceding a list of elements, modify the entire list of elements and do not modify the individual elements of the list. Thus, for example, both "(at least) one of A, B, or C" and "(at least) one of A, B, and C" mean either A, B, C or any combination thereof, in accordance with the current case law.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

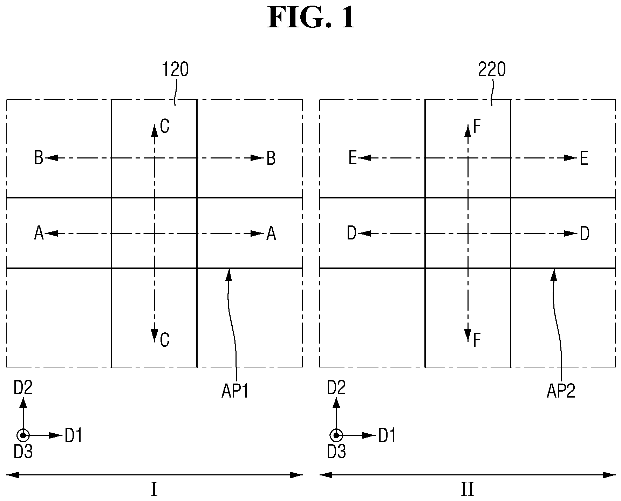

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. A semiconductor device according to some example embodiments will be described with reference to FIGS. 1 to 5.

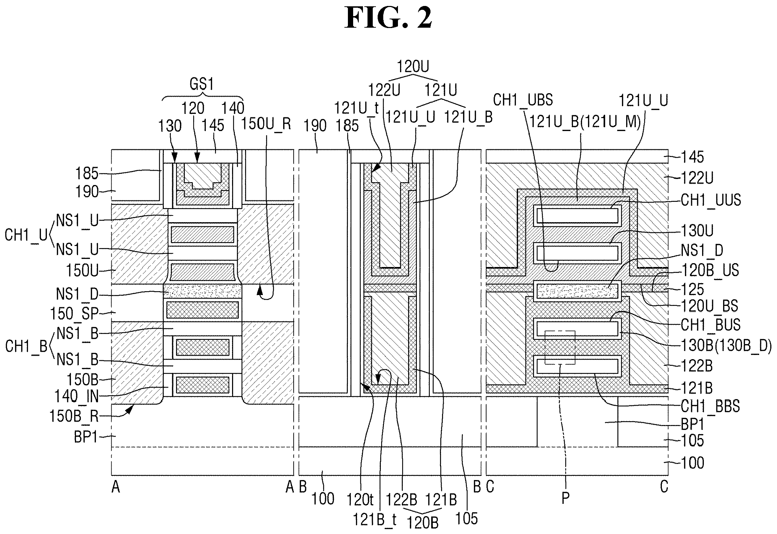

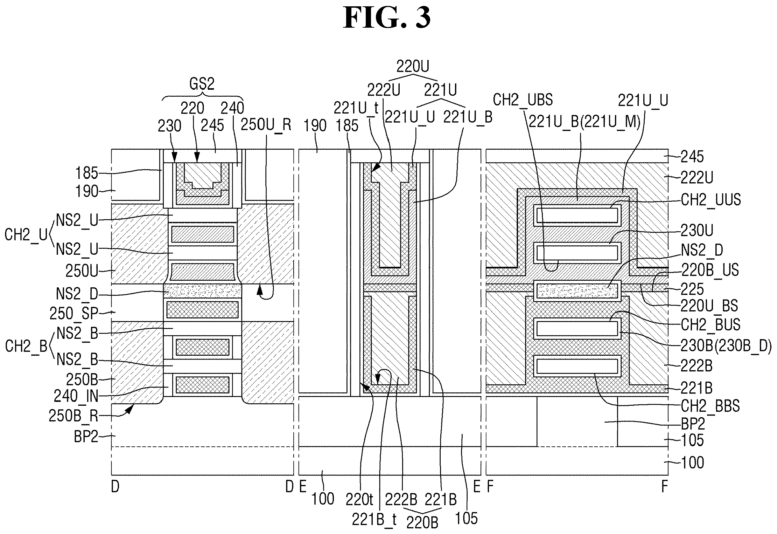

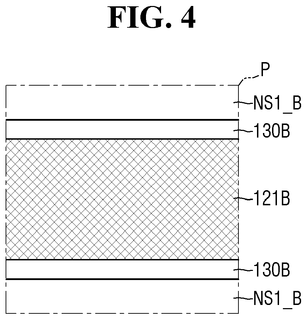

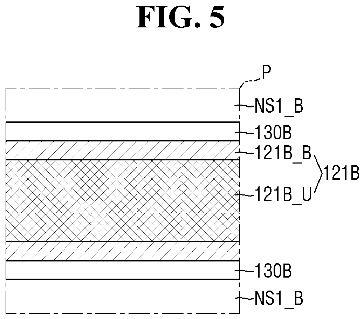

FIG. 1 is a layout diagram illustrating a semiconductor device according to an example embodiment. FIG. 2 shows cross-sectional views taken along lines A-A, B-B and C-C of FIG. 1. FIG. 3 shows cross-sectional views taken along lines D-D, E-E and F-F of FIG. 1. FIGS. 4 and 5 are enlarged views illustrating part P of FIG. 2.

Referring to FIGS. 1 to 5, the semiconductor device according to one example embodiment may include a first active pattern AP1, a first gate electrode 120, a first lower source/drain pattern 150B, a first upper source/drain pattern 150U, a second active pattern AP2, a second gate electrode 220, a second lower source/drain pattern 250B, and a second upper source/drain pattern 250U.

A substrate 100 may include a first region I and a second region II. For example, the first region I and the second region II may be regions adjacent to each other. As another example, the first region I and the second region II may be regions separated from each other. The substrate 100 may include a first region I and a second region II. Each of the first region I and the second region II may be one of a logic region, an SRAM region, or an I/O region.

The substrate 100 may be a bulk silicon or silicon-on-insulator (SOI) substrate. In some example embodiments, the substrate 100 may be a silicon substrate, or may include other materials such as silicon germanium, silicon germanium on insulator (SGOI), indium antimonide, a lead tellurium compound, indium arsenide, indium phosphide, gallium arsenide, or gallium antimonide, but is not limited thereto.

The first active pattern AP1, the first gate electrode 120, the first lower source/drain pattern 150B, and the first upper source/drain pattern 150U may be disposed in the first region I. The second active pattern AP2, the second gate electrode 220, the second lower source/drain pattern 250B, and the second upper source/drain pattern 250U may be disposed in the second region II.

The first active pattern AP1 may include a first lower pattern BP1, a first lower channel pattern CH1_B, a first upper channel pattern CH1_U, and a first dummy sheet pattern NS1_D.

The first lower pattern BP1 may protrude from the substrate 100. The first lower pattern BP1 may be elongated in a first direction D1. The second lower pattern BP2 may protrude from the substrate 100. The second lower pattern BP2 may be elongated in the first direction D1.

Unlike the illustrated example, the second lower pattern BP2 may be elongated in a second direction D2. In this case, the second gate electrode 220 to be described later may extend in the first direction D1. In the following description, the second lower pattern BP2 will be described as being elongated in the first direction D1.

The first lower channel pattern CH1_B may be disposed on the upper surface of the first lower pattern BP1. The first lower sheet pattern NS1_B is spaced apart from the first lower pattern BP1 in a third direction D3.

The first lower channel pattern CH1_B may include at least one first lower sheet pattern NS1_B. When the first lower channel pattern CH1_B includes a plurality of first lower sheet patterns NS1_B, the respective first lower sheet patterns NS1_B are spaced apart from each other in the third direction D3.

The first upper channel pattern CH1_U may be disposed on the first lower channel pattern CH1_B. The first upper channel pattern CH1_U is spaced apart from the first lower channel pattern CH1_B in the third direction D3.

The first upper channel pattern CH1_U may include at least one first upper sheet pattern NS1_U. When the first upper channel pattern CH1_U includes a plurality of first upper sheet patterns NS1_U, the respective first upper sheet patterns NS1_U are spaced apart from each other in the third direction D3.

The first lower channel pattern CH1_B is connected to the first lower source/drain pattern 150B to be described later. The first upper channel pattern CH1_U is connected to the first upper source/drain pattern 150U to be described later.

The first dummy sheet pattern NS1_D may be disposed between the first lower channel pattern CH1_B and the first upper channel pattern CH1_U. The first upper channel pattern CH1_U may be disposed on the first dummy sheet pattern NS1_D. The first lower channel pattern CH1_B may be disposed between the first dummy sheet pattern NS1_D and the first lower pattern BP1.

The first lower channel pattern CH1_B is illustrated to include two first lower sheet patterns NS1_B, but is not limited thereto. The first upper channel pattern CH1_U is illustrated to include two first upper sheet patterns NS 1_U, but is not limited thereto. Unlike the illustrated example, each of the first lower channel pattern CH1_B and the first upper channel pattern CH1_U may include one, or three or more sheet patterns.

The second active pattern AP2 may include the second lower pattern BP2, a second lower channel pattern CH2_B, a second upper channel pattern CH2_U, and a second dummy sheet pattern NS2_D.

The second lower channel pattern CH2_B may be disposed on the upper surface of the second lower pattern BP2. The second lower sheet pattern NS2_B is spaced apart from the second lower pattern BP2 in the third direction D3.

The second lower channel pattern CH2_B may include at least one second lower sheet pattern NS2_B. When the second lower channel pattern CH2_B includes a plurality of second lower sheet patterns NS2_B, the respective second lower sheet patterns NS2_B are spaced apart from each other in the third direction D3.

The second upper channel pattern CH2_U may be disposed on the second lower channel pattern CH2_B. The second upper channel pattern CH2_U is spaced apart from the second lower channel pattern CH2_B in the third direction D3.

The second upper channel pattern CH2_U may include at least one second upper sheet pattern NS2_U. When the second upper channel pattern CH2_U includes a plurality of second upper sheet patterns NS2_U, the respective second upper sheet patterns NS2_U are spaced apart from each other in the third direction D3.

The second lower channel pattern CH2_B is connected to the second lower source/drain pattern 250B to be described later. The second upper channel pattern CH2_U is connected to the second upper source/drain pattern 150U to be described later.

The second dummy sheet pattern NS2_D may be disposed between the second lower channel pattern CH2_B and the second upper channel pattern CH2_U. The second upper channel pattern CH2_U may be disposed on the second dummy sheet pattern NS2_D. The second lower channel pattern CH2_B may be disposed between the second dummy sheet pattern NS2_D and the second lower pattern BP2.

The number of the sheet patterns included in the second lower channel pattern CH2_B is the same as the number of the sheet patterns included in the first lower channel pattern CH1_B. The number of the sheet patterns included in the second upper channel pattern CH2_U is the same as the number of the sheet patterns included in the first upper channel pattern CH1_U.

When the first lower channel pattern CH1_B includes the plurality of first lower sheet patterns NS1_B, an upper surface CH1_BUS of the first lower channel pattern may be the upper surface of the uppermost first lower sheet pattern NS1_B. In addition, a bottom surface CH1_BBS of the first lower channel pattern may be the bottom surface of the lowermost first lower sheet pattern NS1_B.

An upper surface CH2_BUS of the second lower channel pattern may be the upper surface of the uppermost second lower sheet pattern NS2_B. In addition, a bottom surface CH2_BBS of the second lower channel pattern may be the bottom surface of the lowermost second lower sheet pattern NS2_B.

When the first upper channel pattern CH1_U includes the plurality of first upper sheet patterns NS1_U, an upper surface CH1_UUS of the first upper channel pattern may be the upper surface of the uppermost first upper sheet pattern NS1_U. In addition, a bottom surface CH1_UBS of the first upper channel pattern may be the bottom surface of the lowermost first upper sheet pattern NS1_U.

An upper surface CH2_UUS of the second upper channel pattern may be the upper surface of the uppermost second upper sheet pattern NS2_U. Further, a bottom surface CH2_UBS of the second upper channel pattern may be the bottom surface of the lowermost second upper sheet pattern NS2_U.

Each of the first lower pattern BP1 and the second lower pattern BP2 may be formed by etching a part of the substrate 100 or may include an epitaxial layer grown from the substrate 100. The first lower pattern BP1 includes the same material as the second lower pattern BP2. The first lower pattern BP1 and the second lower pattern BP2 may include silicon or germanium, which is an elemental semiconductor material. The first lower pattern BP1 and the second lower pattern BP2 may include a compound semiconductor, for example, a group IV-IV compound semiconductor or a group III-V compound semiconductor.

The group IV-IV compound semiconductor may be a binary compound or a ternary compound including at least two elements selected from the group consisting of carbon (C), silicon (Si), germanium (Ge) and tin (Sn), or the above-mentioned compound doped with a group IV element.

The group III-V compound semiconductor may be, for example, a binary compound, a ternary compound or a quaternary compound formed by combining at least one of aluminum (Al), gallium (Ga) or indium (In), which is a group III element, with one of phosphorus (P), arsenic (As) and antimony (Sb), which is a group V element.

The first lower sheet pattern NS1_B and the second lower sheet pattern NS2_B include the same material. The first lower sheet pattern NS1_B and the second lower sheet pattern NS2_B may include one of silicon or germanium, which is an elemental semiconductor material, a group IV-IV compound semiconductor, and a group III-V compound semiconductor.

The first upper sheet pattern NS1_U and the second upper sheet pattern NS2_U include the same material. The first upper sheet pattern NS1_U and the second upper sheet pattern NS2_U may include one of silicon or germanium, which is an elemental semiconductor material, a group IV-IV compound semiconductor, and a group III-V compound semiconductor.

As an example, the first lower sheet pattern NS1_B includes the same material as the first upper sheet pattern NS1_U. As another example, the first lower sheet pattern NS1_B includes a material different from that of the first upper sheet pattern NS1_U. The following description will be provided for the case in which the first lower sheet pattern NS1_B and the first upper sheet pattern NS1_U include the same material.

For example, the first lower sheet pattern NS1_B may include the same material as the first lower pattern BP1. As another example, the first lower sheet pattern NS1_B may include a material different from that of the first lower pattern BP1.

In semiconductor devices according to some example embodiments, each of the first lower pattern BP1 and the second lower pattern BP2 may be a silicon lower pattern including silicon. The first lower sheet pattern NS1_B, the first upper sheet pattern NS1_U, the second lower sheet pattern NS2_B, and the second upper sheet pattern NS2_U may be a silicon sheet pattern including silicon.

The first dummy sheet pattern NS1_D may include the same material as the second dummy sheet pattern NS2_D. The first dummy sheet pattern NS1_D and the second dummy sheet pattern NS2_D may include an insulating material. The first dummy sheet pattern NS1_D and the second dummy sheet pattern NS2_D may include, for example, at least one of silicon nitride (SiN), silicon oxynitride (SiON), silicon carbide (SiCN), or silicon oxynitride (SiOCN).

Although it is illustrated that the first lower sheet patterns NS1_B stacked in the third direction D3 have the same width in the second direction D2 and the first upper sheet patterns NS1_U stacked in the third direction D3 have the same width in the second direction D2, this is provided only for simplicity of description, and the present disclosure is not limited thereto.

Unlike the illustrated example, the width in the second direction D2 of the first lower sheet patterns NS1_B stacked in the third direction D3 may decrease as the distance from the first lower pattern BP1 increases. In addition, as the distance from the first lower pattern BP1 increases, the width in the second direction D2 of the first upper sheet patterns NS1_U stacked in the third direction D3 may decrease. It is obvious that the above description may also be applicable to the second active pattern AP2.

The first lower channel pattern CH1_B and the first upper channel pattern CH1_U may be included in transistors of different conductivity types. The second lower channel pattern CH2_B and the second upper channel pattern CH2_U may be included in transistors of different conductivity types.

Hereinafter, each of the first lower channel pattern CH1_B and the second lower channel pattern CH2_B will be described as being used as an NMOS channel region. Each of the first upper channel pattern CH1_U and the second upper channel pattern CH2_U will be described as being used as a PMOS channel region.

A field insulating layer 105 may be formed on the substrate 100. The field insulating layer 105 may be disposed on the sidewall of the first lower pattern BP1. The field insulating layer 105 is not disposed on the upper surface of the first lower pattern BP1. The first lower channel pattern CH1_B is disposed higher than the upper surface of the field insulating layer 105.

For example, the field insulating layer 105 may cover the entire sidewall of the first lower pattern BP1. Unlike the illustrated example, the field insulating layer 105 may cover a part of the sidewall of the first lower pattern BP1. In this case, a part of the first lower pattern BP1 may protrude from the upper surface of the field insulating layer 105 in the third direction D3.

The above description may also be applicable to the relationship between the field insulating layer 105 and the second lower pattern BP2.

The field insulating layer 105 may include, for example, an oxide layer, a nitride layer, an oxynitride layer, or a combination layer thereof. Although the field insulating layer 105 is illustrated as being a single layer, this is only for simplicity of description, and the present disclosure is not limited thereto.

Unlike the illustrated example, the first lower channel pattern CH1_B may be directly connected to the first lower pattern BP1. The first lower channel pattern CH1_B and the first lower pattern BP1 may be a fin-type pattern protruding from the substrate 100. The first lower channel pattern CH1_B may be a portion of the fin-type pattern protruding higher than the upper surface of the field insulating layer 105. In this case, as an example, the upper surface CH1_BUS of the first lower channel pattern may be in contact with the first dummy sheet pattern NS1_D. As another example, the upper surface CH1_BUS of the first lower channel pattern may be in contact with the bottom surface of the first dummy sheet pattern NS1_D. The first upper channel pattern CH1_U may also be a fin-type pattern. The bottom surface CH1_UBS of the first upper channel pattern may be in contact with the upper surface of the first dummy sheet pattern NS1_D.

Each of a first gate structure GS1 and a second gate structure GS2 may be disposed on the substrate 100 and the field insulating layer 105. Each of the first gate structure GS1 and the second gate structure GS2 may extend in the second direction D2. When the first active pattern AP1 and the second active pattern AP2 extend in different directions, the direction in which the second gate structure GS2 extends is different from the direction in which the first gate structure GS1 extends.

The first gate structure GS1 may be disposed on the first active pattern AP1. The first gate structure GS1 may cross the first active pattern AP1. The first gate structure GS1 may cross the first lower pattern BP1. The first gate structure GS1 may include, for example, the first gate electrode 120, a first gate insulating layer 130, a first gate spacer 140, and a first gate capping pattern 145.

The second gate structure GS2 may be disposed on the second active pattern AP2. The second gate structure GS2 may cross the second lower pattern BP2. The second gate structure GS2 may include, for example, the second gate electrode 220, a second gate insulating layer 230, a second gate spacer 240, and a second gate capping pattern 245.

The first gate electrode 120 may be disposed on the first lower pattern BP1. The first gate electrode 120 may extend in the second direction D2. The first gate electrode 120 may cross the first lower pattern BP1. The first gate electrode 120 may be disposed in a first gate trench 120t defined by the first gate spacer 140.

The first gate electrode 120 may surround the first lower sheet pattern NS1_B, the first dummy sheet pattern NS1_D, and the first upper sheet pattern NS1_U. The first lower sheet pattern NS1_B, the first dummy sheet pattern NS1_D, and the first upper sheet pattern NS1_U may penetrate the first gate electrode 120. The first gate electrode 120 may be placed between the adjacent first lower sheet patterns NS1_B, and between the adjacent first upper sheet patterns NS1_U. The first gate electrode 120 may be disposed between the first lower sheet pattern NS1_B and the first dummy sheet pattern NS1_D, and between the first upper sheet pattern NS1_U and the first dummy sheet pattern NS1_D. The first gate electrode 120 may be disposed between the first lower pattern BP1 and the first lower sheet pattern NS1_B.

The first gate electrode 120 may include a first lower gate electrode 120B and a first upper gate electrode 120U. The first gate electrode 120 may include a first insertion pattern 125.

The first upper gate electrode 120U is disposed on the first lower gate electrode 120B. The first insertion pattern 125 is disposed between the first upper gate electrode 120U and the first lower gate electrode 120B.

The first lower sheet pattern NS1_B penetrates the first lower gate electrode 120B, but does not penetrate the first upper gate electrode 120U. The first upper sheet pattern NS1_U penetrates the first upper gate electrode 120U, but does not penetrate the first lower gate electrode 120B.

An upper surface 120B_US of the first lower gate electrode faces a bottom surface 120U_BS of the first upper gate electrode. The entire bottom surface 120U_BS of the first upper gate electrode is higher than the upper surface 120B_US of the first lower gate electrode with respect to the upper surface of the first lower pattern BP1 or the upper surface of the field insulating layer 105.

The entire upper surface 120B_US of the first lower gate electrode is disposed between the upper surface CH1_BUS of the first lower channel pattern and the bottom surface CH1_UBS of the first upper channel pattern. In other words, with respect to the upper surface of the first lower pattern BP1 or the upper surface of the field insulating layer 105, the height at which the entire upper surface 120B_US of the first lower gate electrode is located is greater than the height of the upper surface CH1_BUS of the first lower channel pattern and smaller than the height of the bottom surface CH1_UBS of the first upper channel pattern. The entire bottom surface 120U_BS of the first upper gate electrode is disposed between the upper surface CH1_BUS of the first lower channel pattern and the bottom surface CH1_UBS of the first upper channel pattern.

The first insertion pattern 125 may extend along the upper surface 120B_US of the first lower gate electrode. For example, the first insertion pattern 125 may be disposed on the upper surface 120B_US of the first lower gate electrode and may not be disposed on the upper surface of the first dummy sheet pattern NS1_D.

The first insertion pattern 125 is disposed between the upper surface 120B_US of the first lower gate electrode and the bottom surface 120U_BS of the first upper gate electrode. The first lower gate electrode 120B and the first upper gate electrode 120U may be separated in the third direction D3 by the first insertion pattern 125.

The first insertion pattern 125 is disposed between the upper surface CH1_BUS of the first lower channel pattern and the bottom surface CH1_UBS of the first upper channel pattern. In other words, with respect to the upper surface of the first lower pattern BP1 or the upper surface of the field insulating layer 105, the height at which the entire first insertion pattern 125 is located is greater than the height of the upper surface CH1_BUS of the first lower channel pattern and smaller than the height of the bottom surface CH1_UBS of the first upper channel pattern.

The first lower gate electrode 120B includes a first lower conductive liner layer 121B and a first lower filling layer 122B.

The first lower conductive liner layer 121B extends along a part of the sidewall and along the bottom surface of the first gate trench 120t. The first lower conductive liner layer 121B defines a first lower liner trench 121B_t. The first lower conductive liner layer 121B surrounds the first lower sheet pattern NS1_B.

The first lower filling layer 122B is disposed on the first lower conductive liner layer 121B. The first lower filling layer 122B fills the first lower liner trench 121B_t. The entire upper surface 120B_US of the first lower gate electrode is illustrated as being defined by the first lower filling layer 122B, but the present disclosure is not limited thereto.

Only the first lower conductive liner layer 121B of the first lower gate electrode 120B may be disposed in a space between the first lower pattern BP1 and the first lower sheet pattern NS1_B, in a space between the adjacent first lower sheet patterns NS1_B, and in a space between the first lower sheet pattern NS1_B and the first dummy sheet pattern NS1_D. For example, the first lower filling layer 122B is not disposed between the upper surface of the first lower sheet pattern NS1_B and the bottom surface of the first lower sheet pattern NS1_B facing each other.

The first upper gate electrode 120U includes a first upper conductive liner layer 121U and a first upper filling layer 122U.

The first upper conductive liner layer 121U extends along a part of the sidewall of the first gate trench 120t and along the first insertion pattern 125. The first upper conductive liner layer 121U defines a first upper liner trench 121U_t. The first upper conductive liner layer 121U surrounds the first upper sheet pattern NS1_B.

The first upper conductive liner layer 121U may include a lower layer 121U_B of the first upper conductive liner layer and an upper layer 121U_U of the first upper conductive liner layer. The upper layer 121U_U of the first upper conductive liner layer is disposed on the lower layer 121U_B of the first upper conductive liner layer. For example, the upper layer 121U_U of the first upper conductive liner layer may cover the uppermost surface of the lower layer 121U_B of the first upper conductive liner layer. For example, the lower layer 121U_B of the first upper conductive liner layer surrounds the first upper sheet pattern NS1_U.

The first upper liner trench 121U_t may be defined by the upper layer 121U_U of the first upper conductive liner layer. The bottom surface 120U_BS of the first upper gate electrode is defined by the first upper conductive liner layer 121U. For example, the bottom surface 120U_BS of the first upper gate electrode is defined by the lower layer 121U_B of the first upper conductive liner layer. The lower layer 121U_B of the first upper conductive liner layer is spaced apart from the upper surface 120B_US of the first lower gate electrode in the third direction D3.

The first upper filling layer 122U is disposed on the first upper conductive liner layer 121U. The first upper filling layer 122U fills the first upper liner trench 121U_t.

In the semiconductor device according to this example embodiment, only the lower layer 121U_B of the first upper gate electrode 120U may be disposed in a space between the first dummy sheet pattern NS1_D and the first upper sheet pattern NS1_U, and a space between the adjacent first upper sheet patterns NS1_U. For example, the upper layer 121U_U and the first upper filling layer 122U of the first upper conductive liner layer are not disposed between the upper surface of the first upper sheet pattern NS1_U and the bottom surface of the first upper sheet pattern NS1_U facing each other.

The second gate electrode 220 may be disposed on the second lower pattern BP2. The second gate electrode 220 may extend in the second direction D2. The second gate electrode 220 may be disposed in the second gate trench 220t defined by the second gate spacer 240.

The second gate electrode 220 may surround the second lower sheet pattern NS2_B, the second dummy sheet pattern NS2_D, and the second upper sheet pattern NS2_U. The second lower sheet pattern NS2_B, the second dummy sheet pattern NS2_D, and the second upper sheet pattern NS2_U may penetrate the second gate electrode 220.

The second gate electrode 220 may include a second lower gate electrode 220B and a second upper gate electrode 220U. The second gate electrode 220 may include a second insertion pattern 225. The second upper gate electrode 220U is disposed on the second lower gate electrode 220B. The second insertion pattern 225 is disposed between the second upper gate electrode 220U and the second lower gate electrode 220B.

The second lower sheet pattern NS2_B penetrates the second lower gate electrode 220B, but does not penetrate the second upper gate electrode 220U. The second upper sheet pattern NS2_U penetrates the second upper gate electrode 220U, but does not penetrate the second lower gate electrode 220B. The entire bottom surface 220U_BS of the second upper gate electrode is higher than the upper surface 220B_US of the second lower gate electrode with respect to the upper surface of the second lower pattern BP2 or the upper surface of the field insulating layer 105.

The entire upper surface 220B_US of the second lower gate electrode is disposed between the upper surface CH2_BUS of the second lower channel pattern and the bottom surface CH2_UBS of the second upper channel pattern. The entire bottom surface 220U_BS of the second upper gate electrode is disposed between the upper surface CH2_BUS of the second lower channel pattern and the bottom surface CH2_UBS of the second upper channel pattern.

The second insertion pattern 225 may extend along the upper surface 220B_US of the second lower gate electrode. For example, the second insertion pattern 225 may be disposed on the upper surface 220B_US of the second lower gate electrode, and may not be disposed on the upper surface of the second dummy sheet pattern NS2_D.

The second insertion pattern 225 is disposed between the upper surface 220B_US of the second lower gate electrode and the bottom surface 220U_BS of the second upper gate electrode. The second insertion pattern 225 is disposed between the upper surface CH2_BUS of the second lower channel pattern and the bottom surface CH2_UBS of the second upper channel pattern. The second lower gate electrode 220B and the second upper gate electrode 220U may be separated in the third direction D3 by the second insertion pattern 225.

The second lower gate electrode 220B includes a second lower conductive liner layer 221B and a second lower filling layer 222B.

The second lower conductive liner layer 221B extends along a part of the sidewall and the bottom surface of the second gate trench 220t. The second lower conductive liner layer 221B defines a second lower liner trench 221B_t. The second lower filling layer 222B is disposed on the second lower conductive liner layer 221B. The second lower filling layer 222B fills the second lower liner trench 221B_t.

The second lower conductive liner layer 221B surrounds the second lower sheet pattern NS2_B. Only the second lower conductive liner layer 221B of the second lower gate electrode 220B may be disposed in a space between the second lower pattern BP2 and the second lower sheet pattern NS2_B, a space between the adjacent second lower sheet patterns NS2_B, and a space between the second lower sheet pattern NS2_B and the second dummy sheet pattern NS2_D.

The second upper gate electrode 220U includes a second upper conductive liner layer 221U and a second upper filling layer 222U.

The second upper conductive liner layer 221U extends along a part of the sidewall of the second gate trench 220t and the second insertion pattern 225. The second upper conductive liner layer 221U defines a second upper liner trench 221U_t. The second upper conductive liner layer 221U surrounds the second upper sheet pattern NS2_U.

The second upper conductive liner layer 221U may include a lower layer 221U_B of the second upper conductive liner layer and an upper layer 221U_U of the second upper conductive liner layer. The upper layer 221U_U of the second upper conductive liner layer is disposed on the lower layer 221U_B of the second upper conductive liner layer. For example, the lower layer 221U_B of the second upper conductive liner layer surrounds the second upper sheet pattern NS2_U. The second upper liner trench 221U_t may be defined by the upper layer 221U_U of the second upper conductive liner layer. The bottom surface 220U_BS of the second upper gate electrode is defined by the second upper conductive liner layer 221U. For example, the bottom surface 220U_BS of the second upper gate electrode is defined by the lower layer 221U_B of the second upper conductive liner layer.

The second upper filling layer 222U is disposed on the second upper conductive liner layer 221U. The second upper filling layer 222U fills the second upper liner trench 221U_t. In the semiconductor device according to this example embodiment, only the lower layer 221U_B of the second upper conductive liner layer of the second upper gate electrode 220U may be disposed in a space between the second dummy sheet pattern NS2_D and the second upper sheet pattern NS2_U, and a space between the adjacent second upper sheet patterns NS2_U.

The first gate insulating layer 130 may extend along the upper surface of the field insulating layer 105 and along the sidewall and the bottom surface of the first gate trench 120t. The first gate insulating layer 130 is disposed between the first gate electrode 120 and the first lower sheet pattern NS1_B, between the first gate electrode 120 and the first upper sheet pattern NS1_U, and between the first gate electrode 120 and the first dummy sheet pattern NS1_D.

The first lower gate electrode 120B, the first insertion pattern 125, and the first upper gate electrode 120U are disposed on the first gate insulating layer 130. The first lower gate electrode 120B, the first insertion pattern 125, and the first upper gate electrode 120U fill an insulating layer trench defined by the first gate insulating layer 130. The first gate insulating layer 130 may include a first lower gate insulating layer 130B and a first upper gate insulating layer 130U.

The first lower gate insulating layer 130B is disposed between the first gate electrode 120 and the first lower sheet pattern NS1_B. The first lower gate insulating layer 130B may surround the first lower sheet pattern NS1_B. The first lower gate insulating layer 130B may extend along the upper surface of the field insulating layer 105 and along a part of the sidewall of the first gate trench 120t and the bottom surface thereof.

The first upper gate insulating layer 130U is disposed between the first gate electrode 120 and the first upper sheet pattern NS1_U. The first upper gate insulating layer 130U may surround the first upper sheet pattern NS1_U. The first upper gate insulating layer 130U may extend along the rest of the sidewall of the first gate trench 120t.

A part of the first lower gate insulating layer 130B may be disposed between the first lower gate electrode 120B and the first dummy sheet pattern NS1_D. A part of the first upper gate insulating layer 130U may be disposed between the first upper gate electrode 120U and the first dummy sheet pattern NS 1_D.

The second gate insulating layer 230 may extend along the upper surface of the field insulating layer 105 and along the sidewall and the bottom surface of the second gate trench 220t. The second gate insulating layer 230 is disposed between the second gate electrode 220 and the second lower sheet pattern NS2_B, between the second gate electrode 220 and the second upper sheet pattern NS2_U, and between the second gate electrode 220 and the second dummy sheet pattern NS 1_D.

The second lower gate electrode 220B, the second insertion pattern 225, and the second upper gate electrode 220U are disposed on the second gate insulating layer 230. The second lower gate electrode 220B, the second insertion pattern 225, and the second upper gate electrode 220U fill an insulating layer trench defined by the second gate insulating layer 230. The second gate insulating layer 230 may include a second lower gate insulating layer 230B and a second upper gate insulating layer 230U.

The second lower gate insulating layer 230B is disposed between the second gate electrode 220 and the second lower sheet pattern NS2_B. The second lower gate insulating layer 230B may surround the second lower sheet pattern NS2_B. The second lower gate insulating layer 230B may extend along the upper surface of the field insulating layer 105 and along a part of the sidewall of the second gate trench 220t and the bottom surface thereof.

The second upper gate insulating layer 230U is disposed between the second gate electrode 220 and the second upper sheet pattern NS2_U. The second upper gate insulating layer 230U may surround the second upper sheet pattern NS2_U. The second upper gate insulating layer 230U may extend along the rest of the sidewall of the second gate trench 220t.

A part of the second lower gate insulating layer 230B may be disposed between the second lower gate electrode 220B and the second dummy sheet pattern NS2_D. A part of the second upper gate insulating layer 230U may be disposed between the second upper gate electrode 220U and the second dummy sheet pattern NS2_D.

The first gate spacer 140 is disposed on the sidewall of the first gate electrode 120. The first gate spacer 140 may define the first gate trench 120t.

The second gate spacer 240 is disposed on the sidewall of the second gate electrode 220. The second gate spacer 240 may define the second gate trench 220t.

A first inner spacer 140_IN may be disposed between the first lower gate insulating layer 130B and the first lower source/drain pattern 150B. The first inner spacer 140_IN may be disposed between the first lower pattern BP1 and the first lower sheet pattern NS1_B and between the adjacent first lower sheet patterns NS1_B.

A second inner spacer 240_IN may be disposed between the second lower gate insulating layer 230B and the second lower source/drain pattern 250B. The second inner spacer 240_IN may be disposed between the second lower pattern BP2 and the second lower sheet pattern NS2_B and between the adjacent second lower sheet patterns NS2_B.

As an example, the inner spacers 140_IN and 240_IN may not be disposed between at least one of the lower sheet patterns NS1_B and NS2_B and a corresponding one of the dummy sheet patterns NS1_D and NS2_D. Unlike the illustrated example, as another example, the inner spacers 140_IN and 240_IN may be disposed between at least one of the lower sheet patterns NS1_B and NS2_B and a corresponding one of the dummy sheet patterns NS1_D and NS2_D.

The first gate capping pattern 145 may be disposed on the first gate electrode 120 and the first gate spacer 140. The second gate capping pattern 245 may be disposed on the second gate electrode 220 and the second gate spacer 240. The upper surfaces of the gate capping patterns 145 and 245 may be disposed on a same level with the upper surface of an interlayer insulating layer 190. Unlike the illustrated example, the gate capping patterns 145 and 245 may be disposed between the gate spacers 140 and 240.

In the semiconductor device according to this example embodiment, the first lower conductive liner layer 121B and the second lower conductive liner layer 221B may include the same material.

In FIG. 4, the first lower conductive liner layer 121B may be a single layer. For example, the first lower conductive liner layer 121B may include titanium aluminum carbide (TiAlC). The first lower conductive liner layer 121B and the second lower conductive liner layer 221B may be formed of the same material. The second lower conductive liner layer 221B may include TiAlC.

In FIG. 5, the first lower conductive liner layer 121B may include a lower layer 121B_B of the first lower conductive liner layer and an upper layer 121B_U of the first lower conductive liner layer. The lower layer 121B_B of the first lower conductive liner layer may be disposed between the upper layer 121B_U of the first lower conductive liner layer and the first lower sheet pattern NS1_B. For example, the lower layer 121B_B of the first lower conductive liner layer may include titanium nitride (TiN). The upper layer 121B_U of the first lower conductive liner layer may include TiAlC. Likewise, the second lower conductive liner layer 221B may include the same double layer as the first lower conductive liner layer 121B. That is, the second lower conductive liner layer 221B may be formed of the same material as the first lower conductive liner layer 121B.

The first lower filling layer 122B and the second lower filling layer 222B may include the same material. The first lower filling layer 122B and the second lower filling layer 222B may include, for example, at least one of titanium nitride (TiN), tungsten (W), aluminum (Al), ruthenium (Ru), cobalt (Co), titanium (Ti), silver (Ag), or gold (Au), but are not limited thereto. In the following description, the first lower filling layer 122B and the second lower filling layer 222B will be described as including TiN.

The first insertion pattern 125 and the second insertion pattern 225 include the same material. By way of example, the first insertion pattern 125 and the second insertion pattern 225 are formed of the same material.

For example, the first insertion pattern 125 and the second insertion pattern 225 include a conductive material. For example, the first insertion pattern 125 and the second insertion pattern 225 may include tantalum nitride (TaN). The lower gate electrodes 120B and 220B are electrically connected to the upper gate electrodes 120U and 220U by the first insertion pattern 125 and the second insertion pattern 225, respectively.

As another example, the first insertion pattern 125 and the second insertion pattern 225 include an insulating material. In such a case, the lower gate electrodes 120B and 220B are insulated from the upper gate electrodes 120U and 220U by the first insertion pattern 125 and the second insertion pattern 225, respectively.

Because the first insertion pattern 125 and the second insertion pattern 225 are disposed on the lower gate electrode 120B and the lower gate electrode 220B, respectively, the first insertion pattern 125 and the second insertion pattern 225 mitigate or prevent the lower gate electrode 120B and the lower gate electrode 220B from being etched while the upper gate electrodes 120U and 220U are being formed.

The first upper conductive liner layer 121U includes a material different from that of the second upper conductive liner layer 221U. By way of example, the lower layer 121U_B of the first upper conductive liner layer includes a material different from that of the lower layer 221U_B of the second upper conductive liner layer. The upper layer 121U_U of the first upper conductive liner layer includes the same material as the upper layer 221U_U of the second upper conductive liner layer.

Each of the lower layer 121U_B of the first upper conductive liner layer and the lower layer 221U_B of the second upper conductive liner layer may include one of titanium nitride (TiN), titanium oxynitride (TiON), titanium aluminum nitride (TiAlN), tungsten (W), molybdenum nitride (MoN), or tungsten (N), but is not limited thereto.

The upper layer 121U_U of the first upper conductive liner layer and the upper layer 221U_U of the second upper conductive liner layer may include, by way of non-limiting example, titanium aluminum carbide (TiAlC), but are not limited thereto.

Because the lower layer 121U_B of the first upper conductive liner layer includes the material different from that of the lower layer 221U_B of the second upper conductive liner layer, the threshold voltage of a PMOS including the first upper gate electrode 120U may be different from the threshold voltage of a PMOS including the second upper gate electrode 220U. Because the first upper conductive liner layer 121U and the second upper conductive liner layer 221U contain the different materials, the threshold voltage of the transistor may be adjusted differently.

The first upper filling layer 122U and the second upper filling layer 222U may include the same material. The first upper filling layer 122U and the second upper filling layer 222U may include, for example, at least one of titanium nitride (TiN), tungsten (W), aluminum (Al), ruthenium (Ru), cobalt (Co), titanium (Ti), silver (Ag), or gold (Au), but are not limited thereto.

The first gate insulating layer 130 and the second gate insulating layer 230 may include silicon oxide, silicon-germanium oxide, germanium oxide, silicon oxynitride, silicon nitride or a high-k material having a dielectric constant higher than that of silicon oxide. The high-k material may include, for example, one or more of boron nitride, hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, but is not limited thereto.

Although the first gate insulating layer 130 and the second gate insulating layer 230 are illustrated as being a single layer, this is only for simplicity of description, and the present disclosure is not limited thereto. Each of the first gate insulating layer 130 and the second gate insulating layer 230 may include multiple layers. As an example, the first gate insulating layer 130 may include an interfacial layer, which is disposed between the first lower sheet pattern NS1_B and the first gate electrode 120 and between the first upper sheet pattern NS1_U and the first gate electrode 120, and a high-k insulating layer.

The first gate insulating layer 130 includes the same material as the second gate insulating layer 230. The first gate insulating layer 130 and the second gate insulating layer 230 include a matrix layer formed of the same insulating material.

However, the first gate insulating layer 130 and the second gate insulating layer 230 may be doped with different materials. The material doped into the first gate insulating layer 130 and the second gate insulating layer 230 may adjust the threshold voltage of the transistor by controlling a dipole of the insulating layer. When the first gate insulating layer 130 and the second gate insulating layer 230 include hafnium oxide, the first gate insulating layer 130 and the second gate insulating layer 230 include a matrix layer formed of hafnium oxide. However, the material doped into the first gate insulating layer 130 including hafnium oxide may be different from the material doped into the second gate insulating layer 230 including hafnium oxide.

The first lower gate insulating layer 130B surrounding the first lower sheet pattern NS1_B includes the same material as the first upper gate insulating layer 130U surrounding the first upper sheet pattern NS1_U. That is, the first lower gate insulating layer 130B and the first upper gate insulating layer 130U include a matrix layer formed of the same insulating material. The first lower gate insulating layer 130B surrounding the first lower sheet pattern NS1_B includes a first lower doping material doped therein. The first upper gate insulating layer 130U surrounding the first upper sheet pattern NS1_U may not include the first lower doping material.

The second lower gate insulating layer 230B surrounding the second lower sheet pattern NS2_B includes the same material as the second upper gate insulating layer 230U surrounding the second upper sheet pattern NS2_U. The second lower gate insulating layer 230B surrounding the second lower sheet pattern NS2_B includes a second lower doping material doped therein. The second upper gate insulating layer 230U surrounding the second upper sheet pattern NS2_U may not include the second lower doping material.

The first lower doping material doped into the first lower gate insulating layer 130B is different from the second lower doping material doped into the second lower gate insulating layer 230B. Each of the first lower doping material and the second lower doping material may be one of lanthanum (La), aluminum (Al), or zirconium (Zr), but is not limited thereto. The first lower gate insulating layer 130B includes a first lower doping gate insulating layer 130B_D. The second lower gate insulating layer 230B includes a second lower doping gate insulating layer 230B_D.

Different materials may be doped into the first lower gate insulating layer 130B and the second lower gate insulating layer 230B to adjust the dipole of the first lower gate insulating layer 130B and the dipole of the second lower gate insulating layer 230B. Accordingly, the threshold voltage of an NMOS including the first lower gate electrode 120B may become different from the threshold voltage of an NMOS including the second lower gate electrode 220B. Because the different dipole-inducing materials are doped into the first lower gate insulating layer 130B and the second lower gate insulating layer 230B, respectively, the threshold voltages of the transistors may be adjusted differently.

Unlike the above-described example, the first lower gate insulating layer 130B may include the first lower doping material doped therein, whereas the second lower gate insulating layer 230B may include no lower doping material doped therein. The threshold voltage of the transistor may be adjusted differently depending on whether the lower doping material is doped into the lower gate insulating layers 130B and 230B.

The first gate spacer 140, the second gate spacer 240, the first inner spacer 140_IN, and the second inner spacer 240_IN may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), or a combination thereof. Although the first gate spacer 140 and the second gate spacer 240 are illustrated as being a single layer, this is only for simplicity of description, the present disclosure is not limited thereto.

The first gate capping pattern 145 and the second gate capping pattern 245 may include, for example, at least one of silicon nitride (SiN), silicon oxynitride (SiON), silicon carbonitride (SiCN), silicon oxycarbonitride (SiOCN), or a combination thereof. The first gate capping pattern 145 and the second gate capping pattern 245 may include a material having etching selectivity with respect to the interlayer insulating layer 190.

Semiconductor devices according to some example embodiments may include a negative capacitor (NC) FET using a negative capacitor (NC). For example, the first gate insulating layer 130 and the second gate insulating layer 230 may include a ferroelectric material layer having ferroelectric characteristics and a paraelectric material layer having paraelectric characteristics.

The ferroelectric material layer may have a negative capacitance, and the paraelectric material layer may have a positive capacitance. For example, when two or more capacitors are connected in series and the capacitance of each capacitor has a positive value, the total capacitance becomes smaller than the capacitance of each capacitor. On the other hand, when at least one of the capacitances of two or more capacitors connected in series has a negative value, the total capacitance may have a positive value and may be greater than the absolute value of each capacitance.

When a ferroelectric material layer having a negative capacitance and a paraelectric material layer having a positive capacitance are connected in series, the total capacitance value of the ferroelectric material layer and the paraelectric material layer connected in series may increase. By using the principle that the total capacitance value is increased, the transistor containing the ferroelectric material layer may have a subthreshold swing (SS) lower than or equal to a threshold voltage lower than 60 mV/decade at room temperature.

The first lower source/drain pattern 150B is disposed on the first lower pattern BP1. The first lower source/drain pattern 150B may be disposed on at least one side of the first gate structure GS1. The first lower source/drain pattern 150B is connected to the first lower sheet pattern NS1_B.

The first lower source/drain pattern 150B is disposed in a first lower source/drain recess 150B_R. The first lower source/drain recess 150B_R may be defined by the first lower pattern BP1, the first lower sheet pattern NS1_B, and the first inner spacer 140_IN.

The second lower source/drain pattern 250B is disposed on the second lower pattern BP2. The second lower source/drain pattern 250B may be disposed on at least one side of the second gate structure GS2. The second lower source/drain pattern 250B is connected to the second lower sheet pattern NS2_B.

The second lower source/drain pattern 250B is disposed in a second lower source/drain recess 250B_R. The second lower source/drain recess 250B_R may be defined by the second lower pattern BP2, the second lower sheet pattern NS2_B, and the second inner spacer 240_IN.

The first lower source/drain pattern 150B and the second lower source/drain pattern 250B may include an epitaxial pattern. The first lower source/drain pattern 150B and the second lower source/drain pattern 250B include a semiconductor material.

The first lower source/drain pattern 150B and the second lower source/drain pattern 250B may include n-type impurities. The n-type impurities may include at least one of phosphorus (P), arsenic (As), antimony (Sb), or bismuth (Bi).

A first source/drain separation structure 150_SP is disposed on the first lower source/drain pattern 150B. A second source/drain separation structure 250_SP is disposed on the second lower source/drain pattern 250B.

The first source/drain separation structure 150_SP and the second source/drain separation structure 250_SP may include, for example, at least one of silicon oxide, silicon oxynitride, or a low-k material. The low-k material may include, for example, at least one of flowable oxide (FOX), torene silazene (TOSZ), undoped silica glass (USG), borosilica glass (BSG), phosphosilica glass (PSG), borophosphosilica glass (BPSG), plasma enhanced tetra ethyl ortho silicate (PETEOS), fluoride silicate glass (FSG), carbon doped silicon oxide (CDO), Xerogel, Aerogel, amorphous fluorinated carbon, organo silicate glass (OSG), parylene, bis-benzocyclobutene (BCB), SiLK, polyimide, a porous polymeric material, or a combination thereof, but is not limited thereto.

The first upper source/drain pattern 150U is disposed on the first source/drain separation structure 150_SP. The first upper source/drain pattern 150U may be disposed on at least one side of the first gate structure GS1. The first upper source/drain pattern 150U is connected to the first upper sheet pattern NS1_U.

The first source/drain separation structure 150_SP is disposed between the first lower source/drain pattern 150B and the first upper source/drain pattern 150U. The first source/drain separation structure 150_SP electrically separates the first upper source/drain pattern 150U from the first lower source/drain pattern 150B.

The first upper source/drain pattern 150U is disposed in a first upper source/drain recess 150U_R. The first upper source/drain recess 150U_R may be defined by the first source/drain separation structure 150_SP, the first upper sheet pattern NS1_U, and the first upper gate insulating layer 130U. The first upper source/drain pattern 150U may be in contact with the first upper gate insulating layer 130U.

The second upper source/drain pattern 250U is disposed on the second source/drain separation structure 250_SP. The second upper source/drain pattern 250U may be disposed on at least one side of the second gate structure GS2. The second upper source/drain pattern 250U is connected to the second upper sheet pattern NS2_U.

The second source/drain separation structure 250_SP is disposed between the second lower source/drain pattern 250B and the second upper source/drain pattern 250U. The second source/drain separation structure 250_SP electrically separates the second upper source/drain pattern 250U from the second lower source/drain pattern 250B.

The second upper source/drain pattern 250U is disposed in a second upper source/drain recess 250U_R. The second upper source/drain recess 250U_R may be defined by the second source/drain separation structure 250_SP, the second upper sheet pattern NS2_U, and the second upper gate insulating layer 230U. The second upper source/drain pattern 250U may be in contact with the second upper gate insulating layer 230U.

The first upper source/drain pattern 150U and the second upper source/drain pattern 250U may include an epitaxial pattern. The first upper source/drain pattern 150U and the second upper source/drain pattern 250U include a semiconductor material.

The first upper source/drain pattern 150U and the second upper source/drain pattern 250U may include p-type impurities. The p-type impurities may include, but not limited to, boron (B).

A source/drain etching stop layer 185 may be disposed on the sidewall of the first gate structure GS1 and the upper surface of the first upper source/drain pattern 150U. The source/drain etching stop layer 185 may be disposed on the sidewall of the second gate structure GS2 and the second upper source/drain pattern 250U. The source/drain etching stop layer 185 may be disposed on the upper surface of the field insulating layer 105.

The source/drain etching stop layer 185 may include a material having etching selectivity with respect to the interlayer insulating layer 190 to be described later. The source/drain etching stop layer 185 may include, for example, at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), or a combination thereof.

The interlayer insulating layer 190 may be disposed on the source/drain etching stop layer 185. The interlayer insulating layer 190 may be disposed on the first upper source/drain pattern 150U, the first lower source/drain pattern 150B, the second upper source/drain pattern 250U, and the second lower source/drain pattern 250B. The interlayer insulating layer 190 may not cover the upper surface of the first gate capping pattern 145 and the upper surface of the second gate capping pattern 245.

The interlayer insulating layer 190 may include, for example, at least one of silicon oxide, silicon nitride, silicon oxynitride, or a low dielectric constant material.

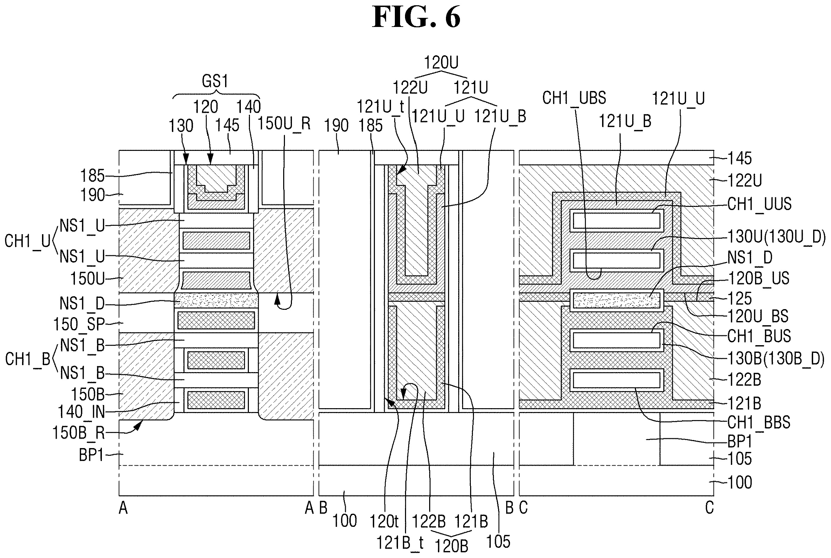

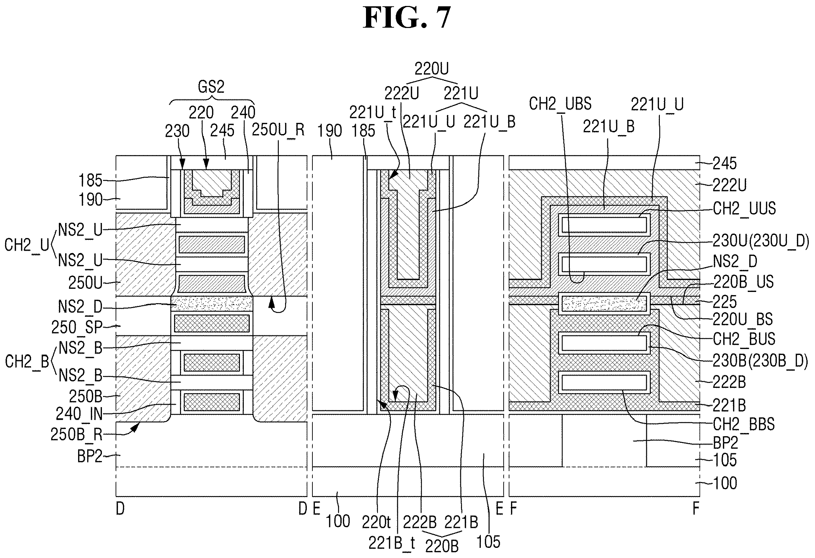

FIGS. 6 and 7 are diagrams illustrating a semiconductor device according to an example embodiment. For simplicity of description, the following description will focus on differences from the description with reference to FIGS. 1 to 5.

Referring to FIGS. 6 and 7, in the semiconductor device according to this example embodiment, the first upper gate insulating layer 130U surrounding the first upper sheet pattern NS1_U includes a first upper doping material doped therein.

The second upper gate insulating layer 230U surrounding the second upper sheet pattern NS2_U includes a second upper doping material doped therein.

By way of example, the first upper conductive liner layer 121U may include the same material as the second upper conductive liner layer 221U. The lower layer 121U_B of the first upper conductive liner layer may include the same material as the lower layer 221U_B of the second upper conductive liner layer. The upper layer 121U_U of the first upper conductive liner layer may include the same material as the upper layer 221U_U of the second upper conductive liner layer.

The first upper doping material doped into the first upper gate insulating layer 130U is different from the second upper doping material doped into the second upper gate insulating layer 230U. The first upper doping material and the second upper doping material may be one of lanthanum (La), aluminum (Al), or zirconium (Zr), but are not limited thereto. The first upper gate insulating layer 130U includes a first upper doping gate insulating layer 130U_D. The second upper gate insulating layer 230U includes a second upper doping gate insulating layer 230U_D.

The threshold voltage of the PMOS including the first upper gate electrode 120U may become different from the threshold voltage of the PMOS including the second upper gate electrode 220U. Because the different dipole-inducing materials are doped into the first upper gate insulating layer 130U and the second upper gate insulating layer 230U, the threshold voltages of the transistors may be adjusted differently.

Unlike the above-described example, the first upper gate insulating layer 130U may include the first upper doping material doped therein, whereas the second upper gate insulating layer 230U may include no upper doping material doped therein. The threshold voltage of the transistor may be adjusted differently depending on whether the upper doping material is doped into the upper gate insulating layers 130U and 230U.

The first upper doping material doped into the first upper gate insulating layer 130U may be different from or the same as the first lower doping material doped into the first lower gate insulating layer 130B. The second upper doping material doped into the second upper gate insulating layer 230U may be different from or the same as the second lower doping material doped into the second lower gate insulating layer 230B.

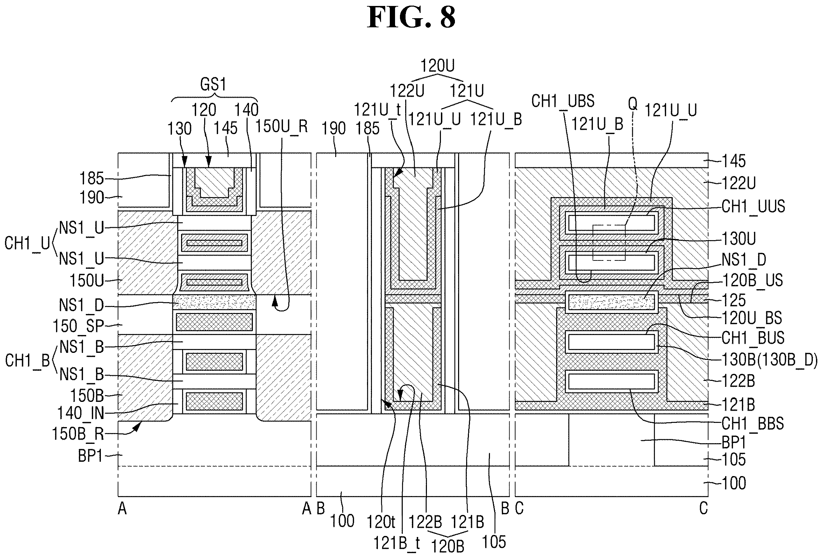

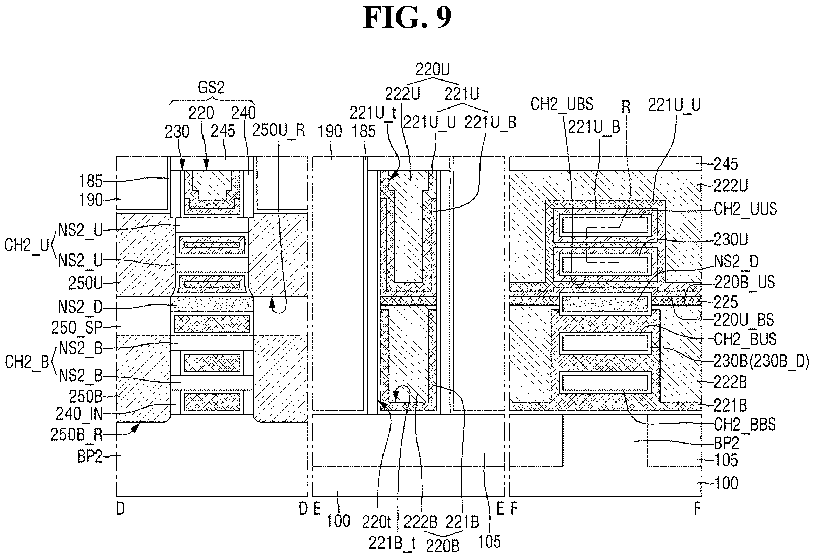

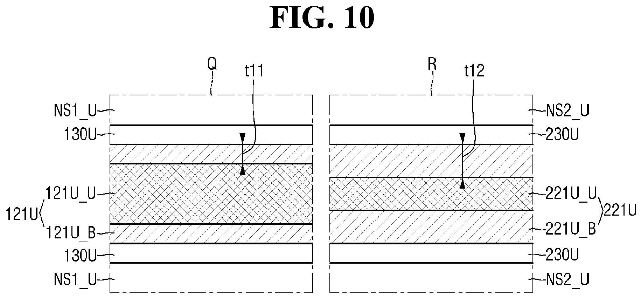

FIGS. 8 to 10 are diagrams illustrating a semiconductor device according to an example embodiment. For simplicity of description, the following description will focus on differences from the description with reference to FIGS. 1 to 5. For reference, FIG. 10 is an enlarged view of part Q and part R of FIGS. 8 and 9.

Referring to FIGS. 8 and 10, in the semiconductor device according to this example embodiment, the lower layer 121U_B of the first upper conductive liner layer includes the same material as the lower layer 221U_B of the second upper conductive liner layer.

For example, the lower layer 121U_B of the first upper conductive liner layer and the lower layer 221U_B of the second upper conductive liner layer may include titanium nitride (TiN).

A thickness t11 of the lower layer 121U_B of the first upper conductive liner layer between the first upper sheet patterns NS1_U adjacent in the third direction D3 is different from a thickness t12 of the lower layer 221U_B of the second upper conductive liner layer between the second upper sheet patterns NS2_U adjacent in the third direction D3. As an example, the thickness t11 of the lower layer 121U_B of the first upper conductive liner layer is the thickness of the lower layer 121U_B of the first upper conductive liner layer extending along the upper surface of the first upper sheet pattern NS1_U or the bottom surface of the first upper sheet pattern NS1_U. In one first upper sheet pattern NS1_U, the upper surface of the first upper sheet pattern NS1_U and the bottom surface of the first upper sheet pattern NS1_U are surfaces opposite to each other in the third direction D3.

Because the thickness t11 of the lower layer 121U_B of the first upper conductive liner layer is different from the thickness t12 of the lower layer 221U_B of the second upper conductive liner layer, the threshold voltage of the PMOS including the first upper gate electrode 120U may be different from the threshold voltage of the PMOS including the second upper gate electrode 220U.

By way of example, the lower layer 121U_B of the first upper conductive liner layer and the upper layer 121U_U of the first upper conductive liner layer may be disposed in a space between the adjacent first upper sheet patterns NS1_U. The lower layer 221U_B of the second upper conductive liner layer and the upper layer 221U_U of the second upper conductive liner layer may be disposed in a space between the adjacent second upper sheet patterns NS2_U.

Unlike the illustrated example, only the lower layer 221U_B of the second upper conductive liner layer may be disposed in the space between the adjacent second upper sheet patterns NS2_U.

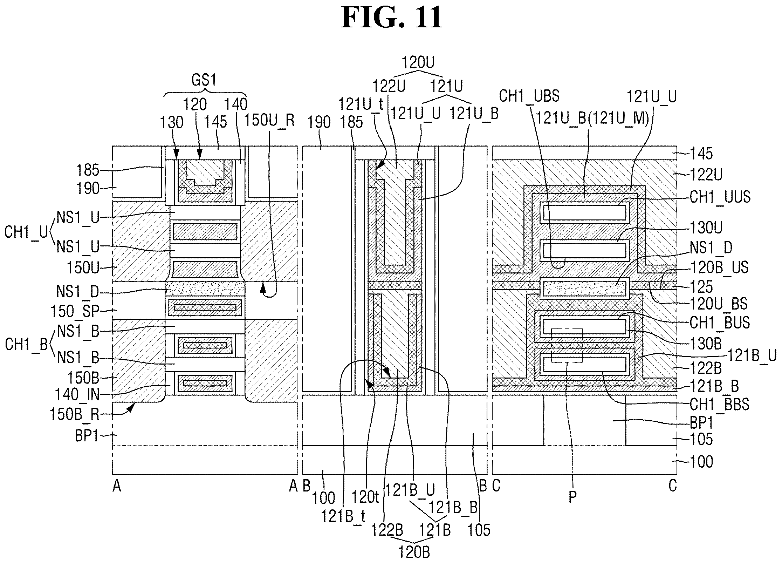

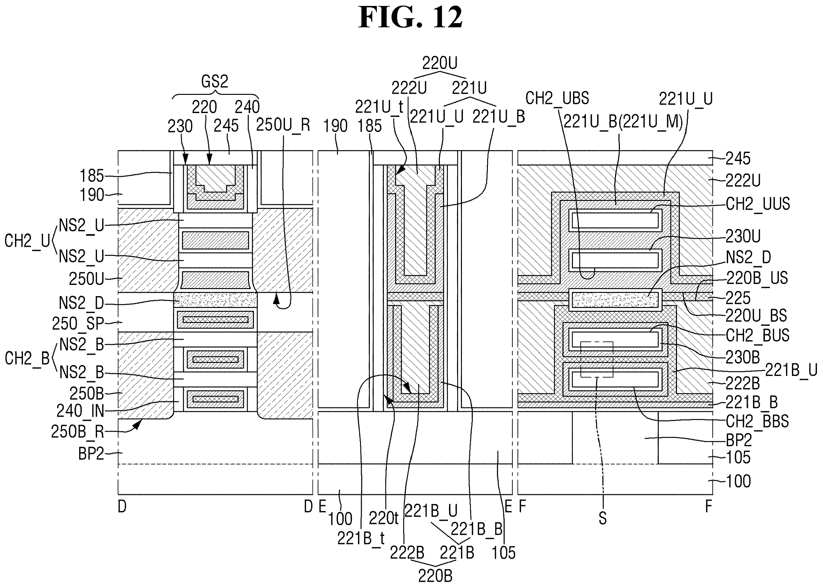

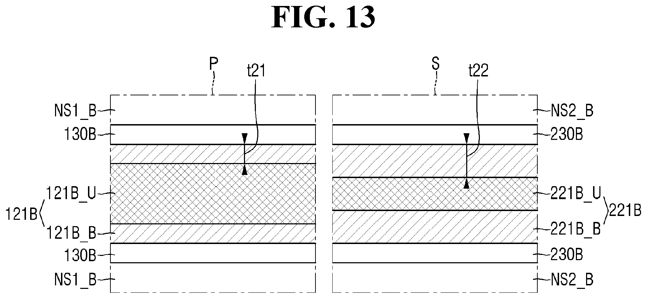

FIGS. 11 to 13 are diagrams illustrating a semiconductor device according to an example embodiment. For simplicity of description, the following description will focus on differences from the description with reference to FIGS. 1 to 5. For reference, FIG. 13 is an enlarged view of part P and part S of FIGS. 11 and 12.

Referring to FIGS. 11 to 13, in the semiconductor device according to this example embodiment, the first lower conductive liner layer 121B may include the lower layer 121B_B of the first lower conductive liner layer and the upper layer 121B_U of the first lower conductive liner layer.

The second lower conductive liner layer 221B may include a lower layer 221B_B of the second lower conductive liner layer and an upper layer 221B_U of the second lower conductive liner layer.

The lower layer 121B_B of the first lower conductive liner layer and the lower layer 221B_B of the second lower conductive liner layer may include the same material. The lower layer 121B_B of the first lower conductive liner layer and the lower layer 221B_B of the second lower conductive liner layer may include titanium nitride (TiN).

The upper layer 121B_U of the first lower conductive liner layer and the upper layer 221B_U of the second lower conductive liner layer may include the same material. The upper layer 121B_U of the first lower conductive liner layer and the upper layer 221B_U of the second lower conductive liner layer may include titanium aluminum carbide (TiAlC).

The first lower gate insulating layer 130B surrounding the first lower sheet pattern NS1_B may not include the first lower doping material doped therein. The second lower gate insulating layer 230B surrounding the second lower sheet pattern NS2_B may not include the second lower doping material doped therein.

A thickness t21 of the lower layer 121B_B of the first lower conductive liner layer between the first lower sheet patterns NS1_B adjacent in the third direction D3 is different from a thickness t22 of the lower layer 221B_B of the second lower conductive liner layer between the second lower sheet patterns NS2_B adjacent in the third direction D3. For example, the thickness t21 of the lower layer121B_B of the first lower conductive liner layer is the thickness of the lower layer 121B_B of the first lower conductive liner layer extending along the upper surface of the first lower sheet pattern NS1_B or the bottom surface of the first lower sheet pattern NS1_B.

Because the thickness t21 of the lower layer 121B_B of the first lower conductive liner layer is different from the thickness t22 of the lower layer 221B_B of the second lower conductive liner layer, the threshold voltage of an NMOS transistor including the first lower gate electrode 120B may be different from the threshold voltage of another NMOS transistor including the second lower gate electrode 220B.

For example, the lower layer 121B_B of the first lower conductive liner layer and the upper layer 121B_U of the first lower conductive liner layer may be disposed in a space between the adjacent first lower sheet patterns NS1_B. The lower layer 221B_B of the second lower conductive liner layer and the upper layer 221B_U of the second lower conductive liner layer may be disposed in a space between the adjacent second lower sheet patterns NS2_B.

Unlike the illustrated example, only the lower layer 221B_B of the second lower conductive liner layer may be disposed in the space between the adjacent second lower sheet patterns NS2_B.

Unlike the illustrated example, the first lower conductive liner layer 121B may include only the upper layer 121B_U of the first lower conductive liner layer without having the lower layer 121B_B of the first lower conductive liner layer. The threshold voltage of the transistor may be adjusted differently depending on whether or not the lower layer 121B_B of the first lower conductive liner layer exists.

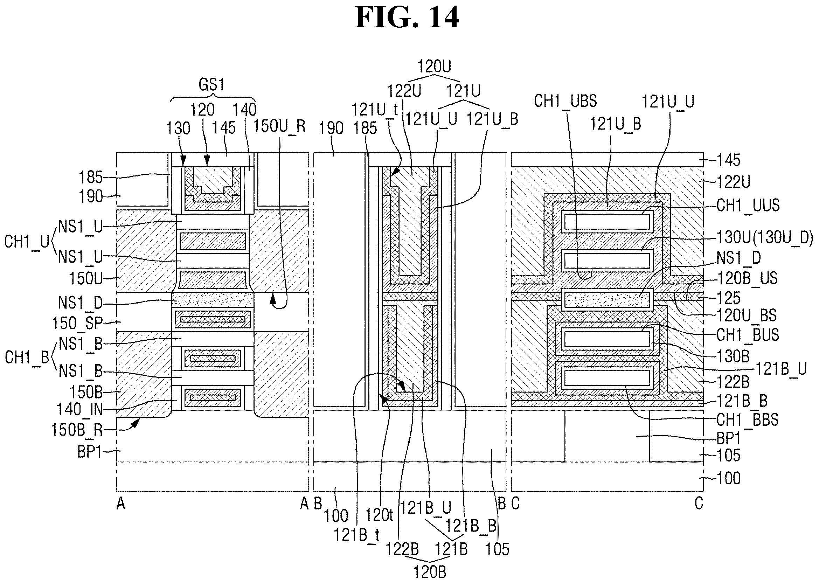

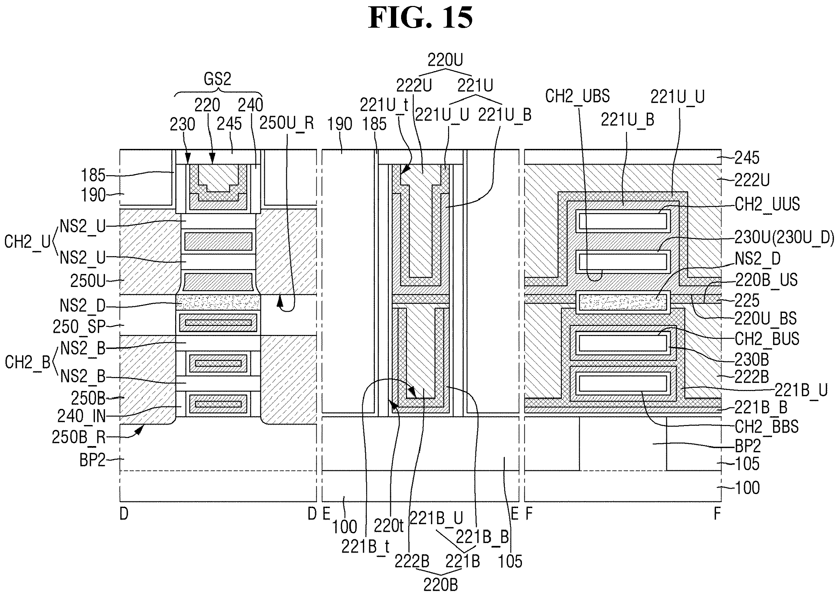

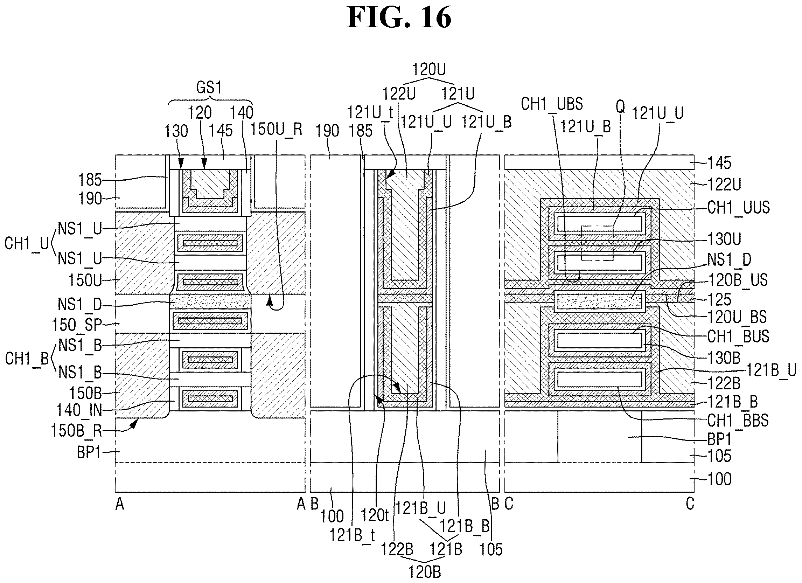

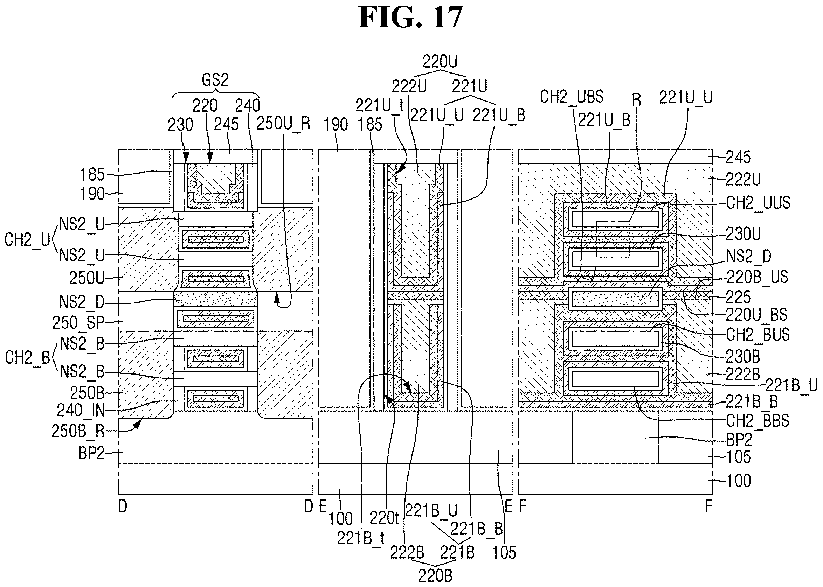

FIGS. 14 and 15 are diagrams illustrating a semiconductor device according to an example embodiment. FIGS. 16 and 17 are diagrams illustrating a semiconductor device according to an example embodiment. For simplicity of description, the following description will focus on differences from the description with reference to FIGS. 11 to 13. For reference, an enlarged view of part Q of FIG. 16 and an enlarged view of part R of FIG. 17 is substantially the same as FIG. 10.

Referring to FIGS. 14 and 15, the first upper gate insulating layer 130U surrounding the first upper sheet pattern NS1_U includes the first upper doping material doped therein.

The second upper gate insulating layer 230U surrounding the second upper sheet pattern NS2_U includes the second upper doping material doped therein.

The first upper doping material doped into the first upper gate insulating layer 130U is different from the second upper doping material doped into the second upper gate insulating layer 230U. The first upper gate insulating layer 130U includes the first upper doping gate insulating layer 130U_D. The second upper gate insulating layer 230U includes the second upper doping gate insulating layer 230U_D.

Because the different dipole-inducing materials are doped into the first upper gate insulating layer 130U and the second upper gate insulating layer 230U, the threshold voltages of the transistors may be adjusted differently.

The first upper conductive liner layer 121U may include the same material as the second upper conductive liner layer 221U. The lower layer 121U_B of the first upper conductive liner layer may include the same material as the lower layer 221U_B of the second upper conductive liner layer. The upper layer 121U_U of the first upper conductive liner layer may include the same material as the upper layer 221U_U of the second upper conductive liner layer.

Referring to FIGS. 16 and 17, the lower layer 121U_B of the first upper conductive liner layer includes the same material as the lower layer 221U_B of the second upper conductive liner layer.

For example, the lower layer 121U_B of the first upper conductive liner layer and the lower layer 221U_B of the second upper conductive liner layer may include titanium nitride (TiN).

In FIG. 10, the thickness t11 of the lower layer 121U_B of the first upper conductive liner layer between the first upper sheet patterns NS1_U adjacent in the third direction D3 is different from the thickness t12 of the lower layer 221U_B of the second upper conductive liner layer between the second upper sheet patterns NS2_U adjacent in the third direction D3. Because the thicknesses of the lower layers 121U_B and 221U_B of the upper conductive liner layer are different, the threshold voltages of the transistors may be adjusted differently.

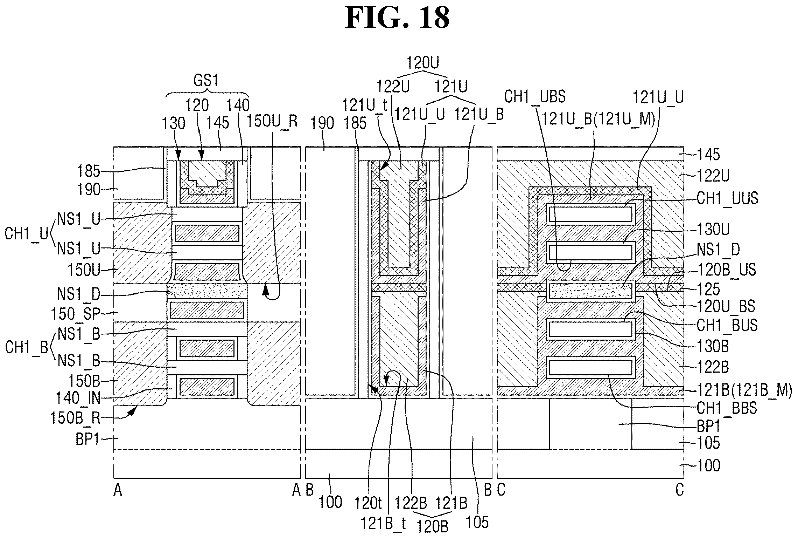

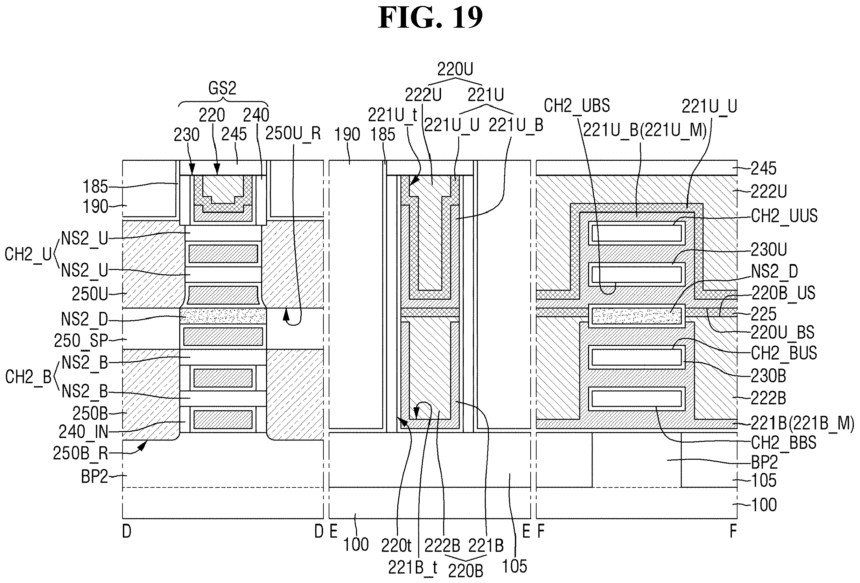

FIGS. 18 and 19 are diagrams illustrating a semiconductor device according to an example embodiment. For simplicity of description, the following description will focus on differences from the description with reference to FIGS. 1 to 5.

Referring to FIGS. 18 and 19, in the semiconductor device according to this example embodiment, the first lower conductive liner layer 121B includes a material different from that of the second lower conductive liner layer 221B.

The first lower conductive liner layer 121B may include a first lower work function layer 121B_M. The second lower conductive liner layer 221B may include a second lower work function layer 221B_M different from the first lower work function layer 121B_M. The first lower conductive liner layer 121B and the second lower conductive liner layer 221B may include one of titanium nitride (TiN), titanium oxynitride (TiON), titanium aluminum nitride (TiAlN), titanium aluminum carbide (TiAlC), tungsten (W), molybdenum nitride (MoN), or tungsten carbonitride (WCN), but are not limited thereto.

Because the first lower conductive liner layer 121B includes the material different from that of the second lower conductive liner layer 221B, the threshold voltages of the transistors may be adjusted differently.

The first lower gate insulating layer 130B surrounding the first lower sheet pattern NS1_B may not include the first lower doping material doped therein. The second lower gate insulating layer 230B surrounding the second lower sheet pattern NS2_B may not include the second lower doping material doped therein.

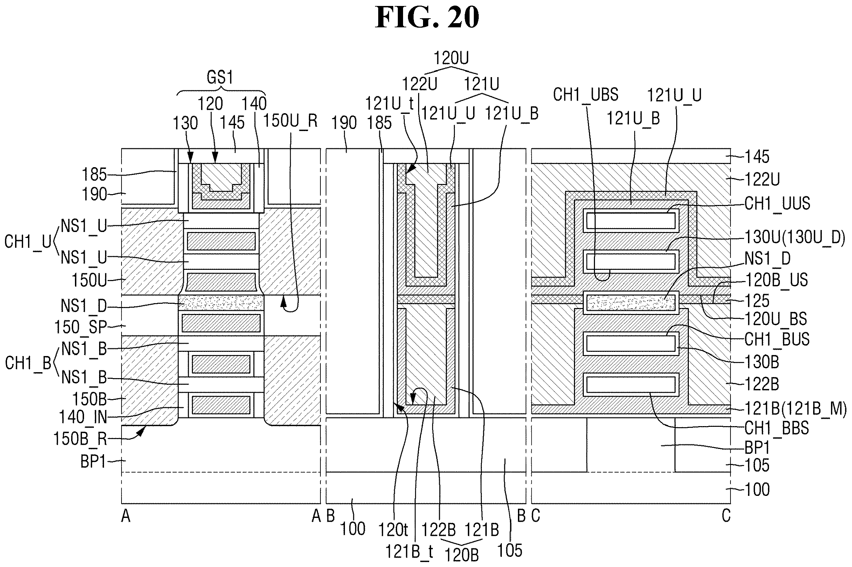

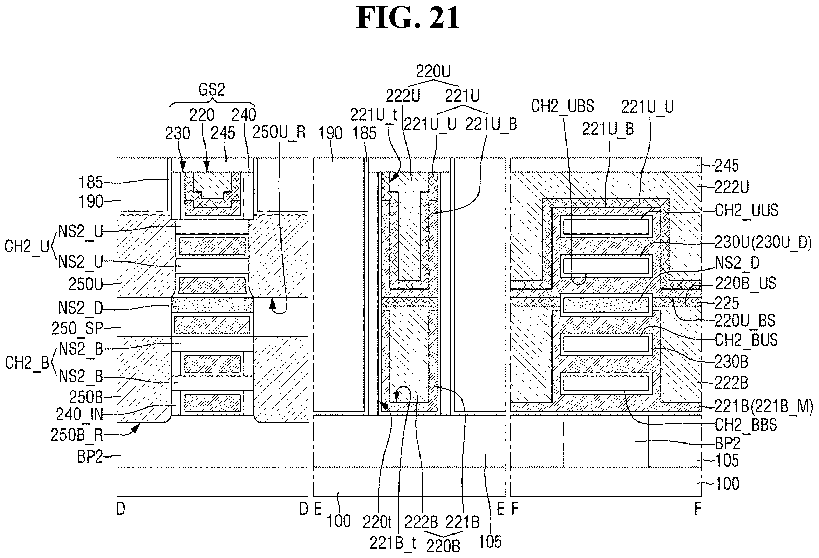

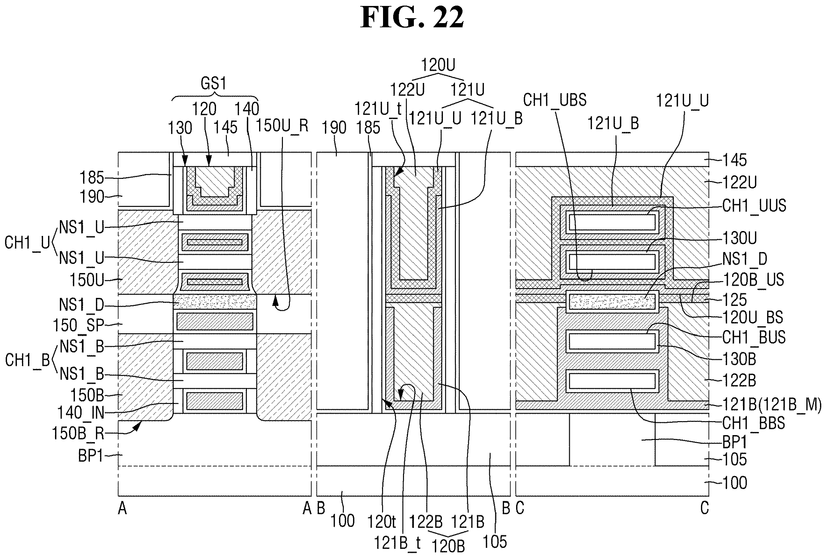

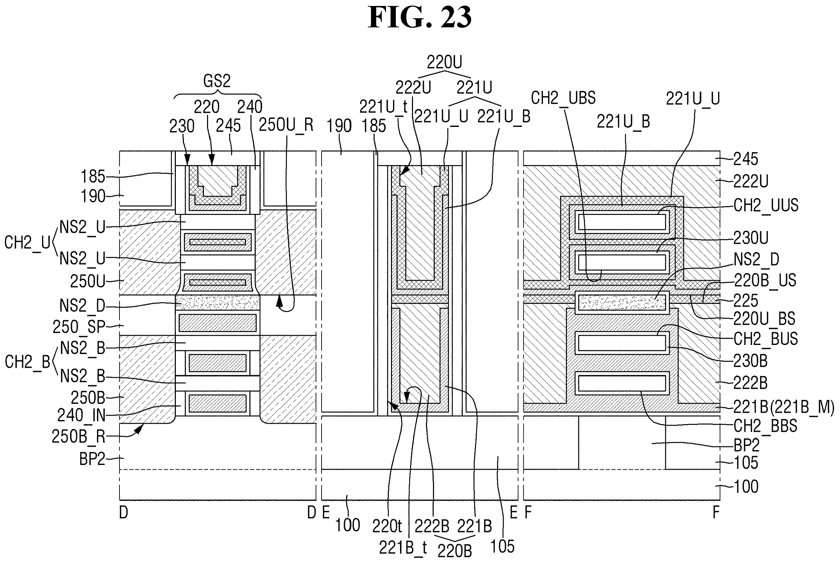

FIGS. 20 and 21 are diagrams illustrating a semiconductor device according to an example embodiment. FIGS. 22 and 23 are diagrams illustrating a semiconductor device according to an example embodiment. For simplicity of description, the following description will focus on differences from the description with reference to FIGS. 18 and 19.

Referring to FIGS. 20 and 21, the lower layer 121U_B of the first upper conductive liner layer may include the same material as the lower layer 221U_B of the second upper conductive liner layer. The upper layer 121U_U of the first upper conductive liner layer may include the same material as the upper layer 221U_U of the second upper conductive liner layer.

The first upper gate insulating layer 130U surrounding the first upper sheet pattern NS1_U includes the first upper doping material doped therein. The second upper gate insulating layer 230U surrounding the second upper sheet pattern NS2_U includes the second upper doping material doped therein.

The first upper doping material doped into the first upper gate insulating layer 130U is different from the second upper doping material doped into the second upper gate insulating layer 230U. The first upper gate insulating layer 130U includes the first upper doping gate insulating layer 130U_D. The second upper gate insulating layer 230U includes the second upper doping gate insulating layer 230B_D.

Referring to FIGS. 22 and 23, in the semiconductor device according to an example embodiment, the lower layer 121U_B of the first upper conductive liner layer and the lower layer 221U_B of the second upper conductive liner layer may include titanium nitride (TiN).

In FIG. 10, the thickness t11 of the lower layer 121U_B of the first upper conductive liner layer disposed between the first upper sheet patterns NS1_U adjacent in the third direction D3 is different from the thickness t12 of the lower layer 221U_B of the second upper conductive liner layer between the second upper sheet patterns NS2_U adjacent in the third direction D3.

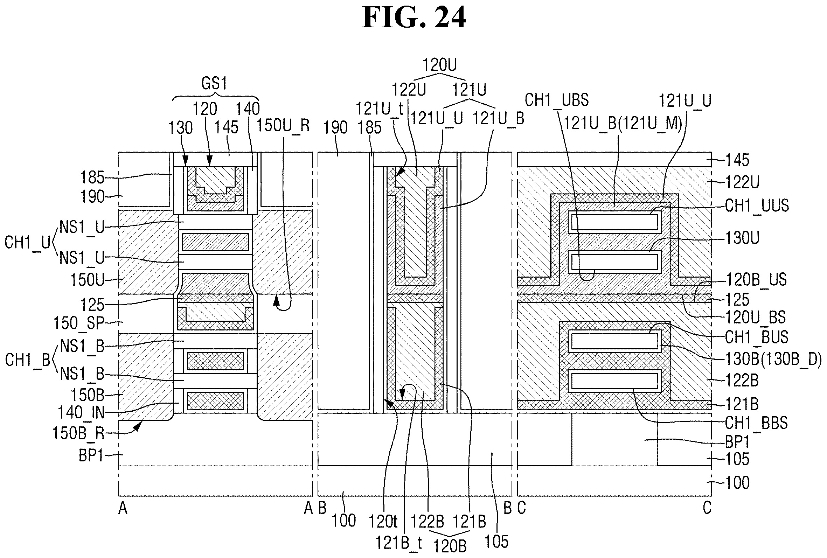

FIGS. 24 to 27 are diagrams each illustrating a semiconductor device according to some example embodiments. For simplicity of description, the following description will focus on differences from the description with reference to FIGS. 1 to 5.

Referring to FIG. 24, in the semiconductor device according to an example embodiment, the first dummy sheet pattern (NS1_D of FIG. 2) is not disposed between the first lower channel pattern CH1_B and the first upper channel pattern CH1_U.

In cross-sectional view taken along line A-A, the first insertion pattern 125 is disposed between the upper surface of the first lower sheet pattern NS1_B and the bottom surface of the first upper sheet pattern NS1_U facing each other.

Although not illustrated, the second dummy sheet pattern (NS2_D of FIG. 3) is not disposed between the second lower channel pattern (CH2_B of FIG. 3) and the second upper channel pattern (CH2_U of FIG. 3).

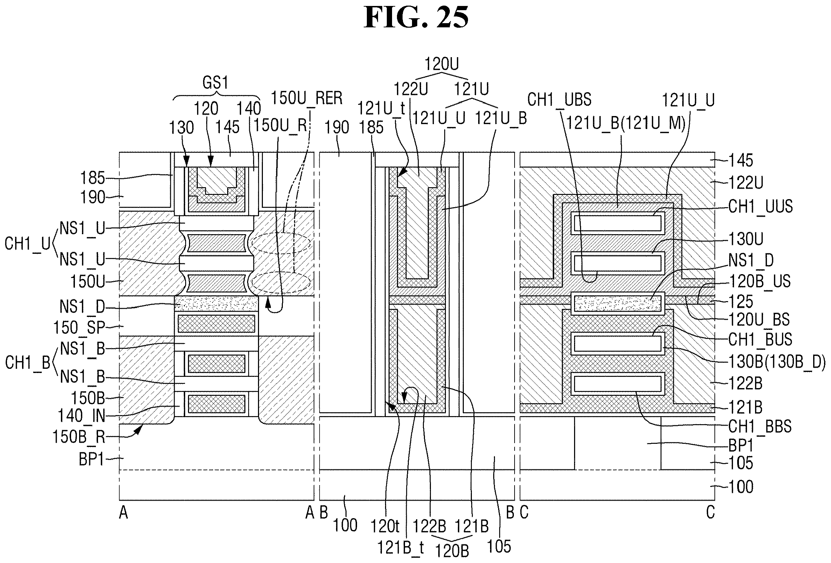

Referring to FIG. 25, in the semiconductor device according to an example embodiments, the first upper source/drain recess 150U_R may include a plurality of width expansion regions 150U_RER.

Each of the width expansion regions 150U_RER may be defined above the upper surface of the first source/drain separation structure 150_SP. The width expansion region 150U_RER may be defined between the first upper sheet patterns NS1_U adjacent to each other in the third direction D3. The width expansion region 150U_RER may be defined between the first dummy sheet pattern NS1_D and the first upper sheet pattern NS1_U.

Each width expansion region 150U_RER may include a portion whose width in the first direction D1 increases and a portion whose width in the first direction D1 decreases as the distance from the upper surface of the first source/drain separation structure 150_SP increases. For example, the width of the width expansion region 150U_RER may first increase and then decrease as it moves away from the upper surface of the first source/drain separation structure 150_SP.

Although not shown, the second upper source/drain recess (250U_R of FIG. 3) may also include the width expansion region 150U_RER.

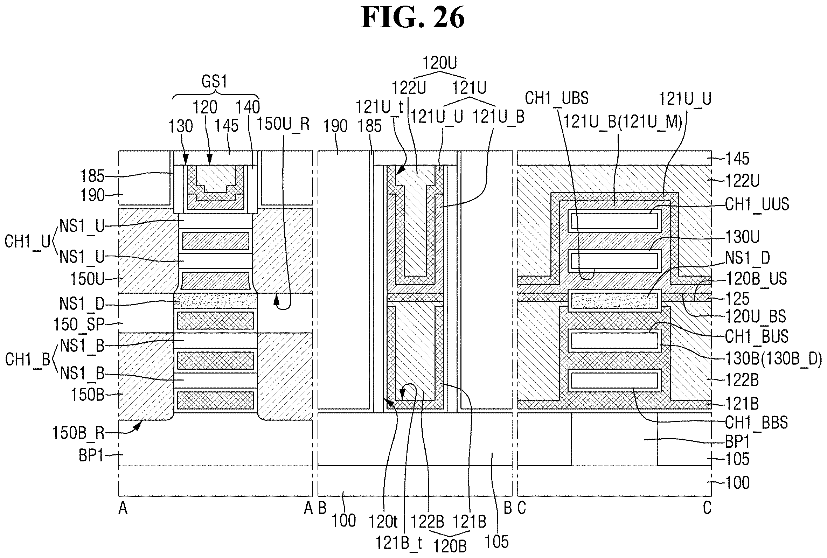

Referring to FIG. 26, in the semiconductor device according to an example embodiment, the first gate structure GS1 does not include the first inner spacer (140_IN of FIG. 2).

The first lower source/drain recess 150B_R may be defined by the first lower pattern BP1, the first lower sheet pattern NS1_B, and the first lower gate insulating layer 130B. The first lower source/drain pattern 150B may be in contact with the first lower gate insulating layer 130B.

Although not shown, the second gate structure (GS2 of FIG. 3) does not include the second inner spacer (240_IN of FIG. 3).

Unlike the illustrated example, the first lower source/drain recess 150B_R may include the width expansion region 150U_RER as illustrated in FIG. 25.

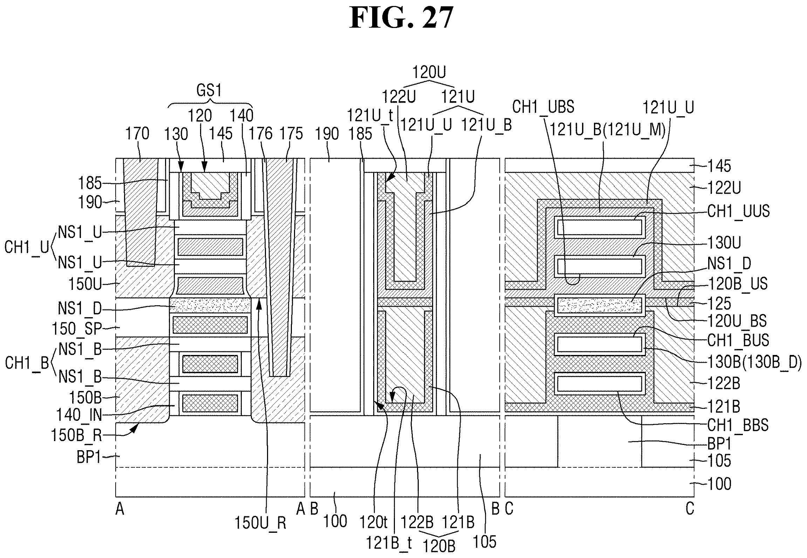

Referring to FIG. 27, the semiconductor device according to an example embodiment may further include a first upper source/drain contact 170 and a first lower source/drain contact 175.

The first upper source/drain contact 170 is connected to the first upper source/drain pattern 150U. The first lower source/drain contact 175 is connected to the first lower source/drain pattern 150B.

Although the first upper source/drain contact 170 and the first lower source/drain contact 175 are illustrated as being a single layer, this is only for simplicity of description, and the present disclosure is not limited thereto. Each of the first upper source/drain contact 170 and the first lower source/drain contact 175 may include, for example, at least one of a metal, a metal alloy, conductive metal nitride, conductive metal carbide, conductive metal oxide, conductive metal carbonitride, or a two-dimensional (2D) material.

Although not shown, an upper metal silicide layer may be formed between the first upper source/drain contact 170 and the first upper source/drain pattern 150U. In addition, a lower metal silicide layer may be formed between the first lower source/drain contact 175 and the first lower source/drain pattern 150B. The upper metal silicide layer and the lower metal silicide layer may include metal silicide.

A contact separation layer 176 may extend along the sidewall of the first lower source/drain contact 175. The contact separation layer 176 may electrically insulate the first upper source/drain pattern 150U from the first lower source/drain contact 175. Unlike the illustrated example, if the first lower source/drain contact 175 is connected to the first upper source/drain pattern 150U as well as the first lower source/drain pattern 150B, the contact separation layer176 may not be disposed on the sidewall of the first lower source/drain contact 175. The contact separation layer 176 is formed of an insulating material.

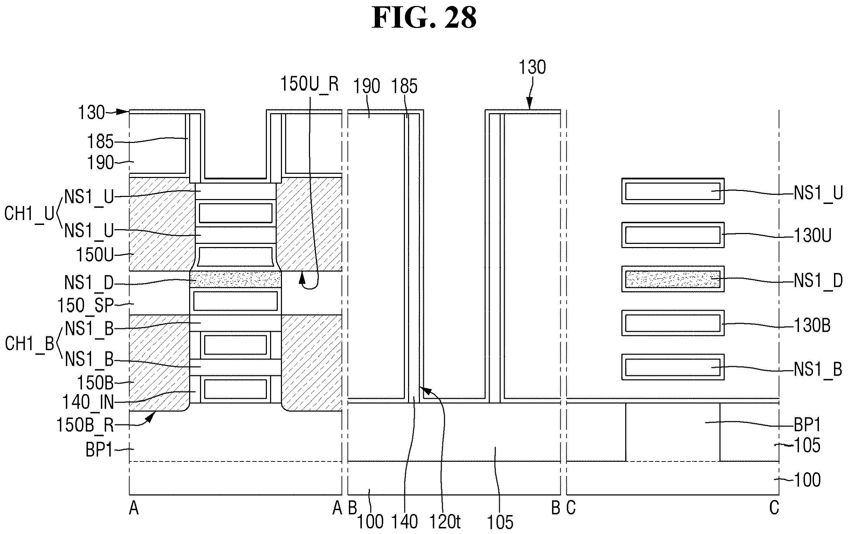

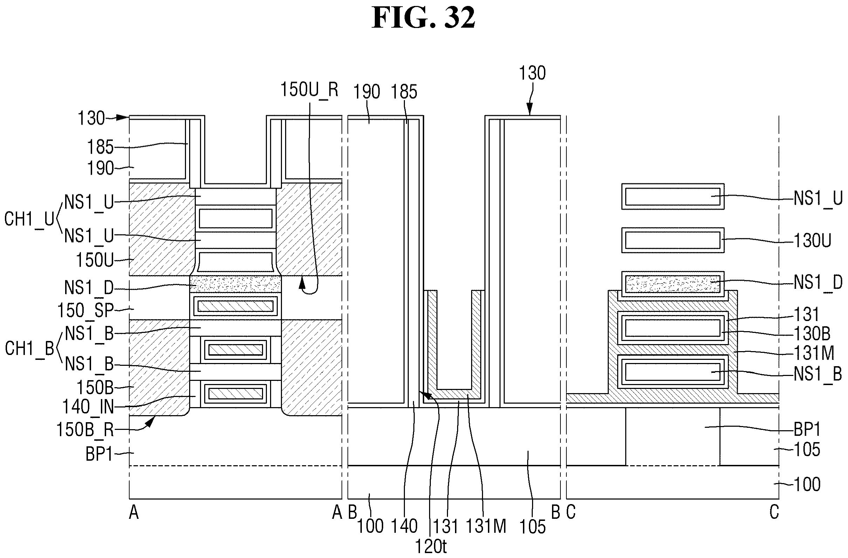

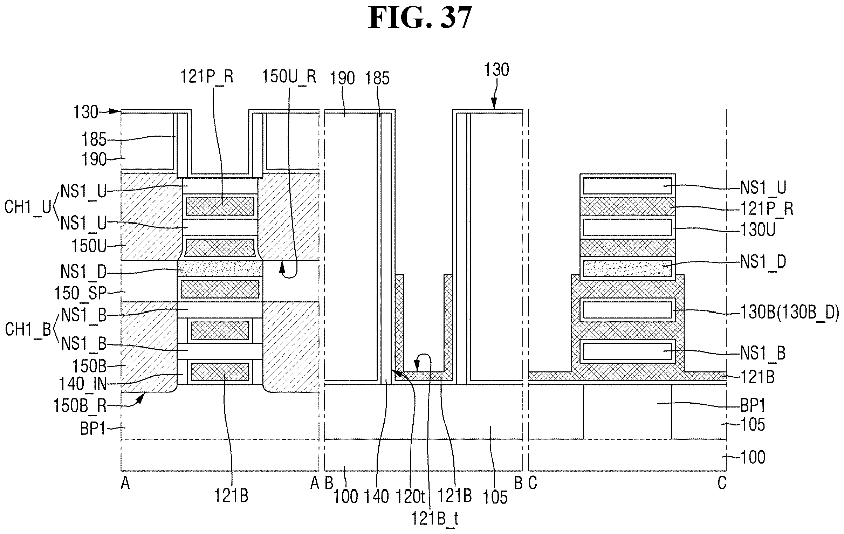

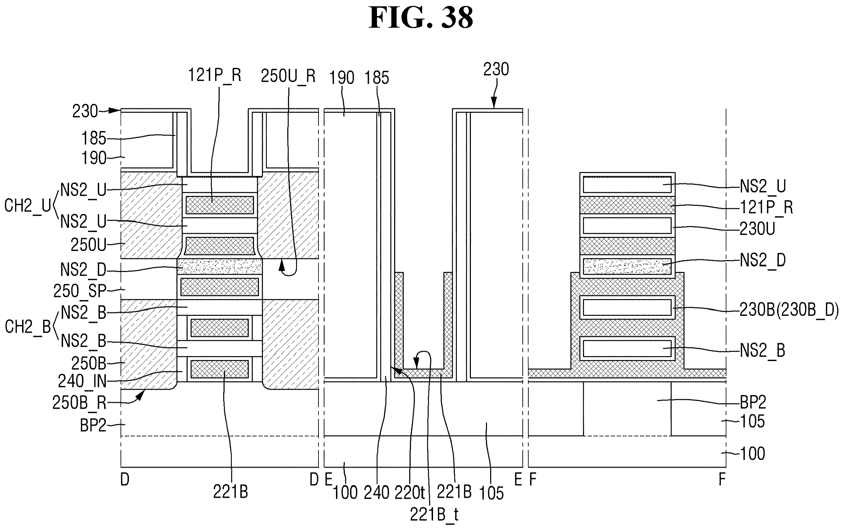

FIGS. 28 to 46 are views illustrating the intermediate steps of a method of fabricating a semiconductor device according to an example embodiment.

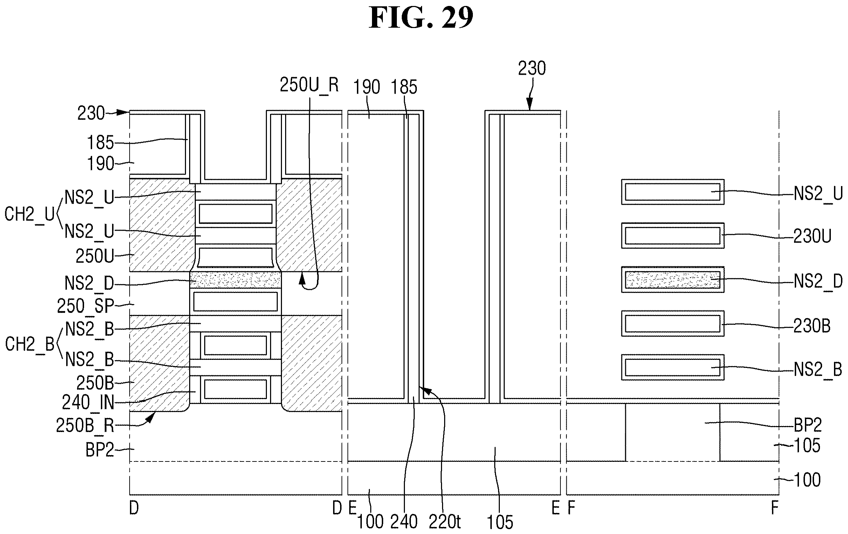

Referring to FIGS. 28 and 29, the first gate spacer 140 defining the first gate trench 120t is formed on the first lower pattern BP1 extending in the first direction (D1 of FIG. 1).

The second gate spacer 240 defining the second gate trench 220t is formed on the second lower pattern BP2 extending in the first direction (D1 in FIG. 1).

For example, a first fin-type pattern and a second fin-type pattern may be formed on the substrate 100. The first fin-type pattern may include the first lower pattern BP1, an active layer, a sacrificial layer, and a buffer layer. The second fin-type pattern may include the second lower pattern BP2, an active layer, a sacrificial layer, and a buffer layer.

Subsequently, a first dummy gate electrode and a first dummy gate spacer are formed on the first fin-type pattern. A second dummy gate electrode and a second dummy gate spacer are formed on the second fin-type pattern.

After the first dummy gate electrode and the second dummy gate electrode are formed, the buffer layer included in the first fin-type pattern and the second fin-type pattern may be replaced with a dummy sheet layer. First, the buffer layer is removed to form a buffer space in the first-fin type pattern and the second fin-type pattern. The buffer space is then filled with an insulating material. Accordingly, a dummy sheet layer may be formed.

Subsequently, the first lower source/drain pattern 150B is formed on the first lower pattern BP1. Before the first lower source/drain pattern 150B is formed, the first inner spacer 140_IN may be formed. The second lower source/drain pattern 250B is formed on the second lower pattern BP2, and the second lower source/drain pattern 250B is formed simultaneously with the first lower source/drain pattern 150B.

While the first lower source/drain pattern 150B and the second lower source/drain pattern 250B are being formed, the dummy sheet layer may be patterned. Accordingly, the first dummy sheet pattern NS1_D and the second dummy sheet pattern NS2_D are formed.

Subsequently, the first source/drain separation structure 150_SP is formed on the first lower source/drain pattern 150B. The second source/drain separation structure 250_SP is formed on the second lower source/drain pattern 250B. The first source/drain separation structure 150_SP is formed simultaneously with the second source/drain separation structure 250_SP.

Subsequently, the first upper source/drain pattern 150U and the second upper source/drain pattern 250U are simultaneously formed on the first source/drain separation structure 150_SP and the second source/drain separation structure 250_SP, respectively.

The source/drain etching stop layer 185 and the interlayer insulating layer 190 are sequentially formed on the first upper source/drain pattern 150U and the second upper source/drain pattern 250U.

After the interlayer insulating layer 190 is formed, the first dummy gate electrode and a second dummy gate electrode may be exposed through a planarization process. While the first dummy gate electrode and the second dummy gate electrode are exposed, the first gate spacer 140 and the second gate spacer 240 are formed.

Subsequently, the first dummy gate electrode and the second dummy gate electrode are removed to form the first gate trench 120t and the second gate trench 220t.

Subsequently, by removing the sacrificial layer included in the first fin-type pattern, the first lower channel pattern CH1_B and the first upper channel pattern CH1_U are formed on the first lower pattern BP1. By removing the sacrificial layer included in the second fin-type pattern, the second lower channel pattern CH2_B and the second upper channel pattern CH2_U are formed on the second lower pattern BP2. The first lower channel pattern CH1_B and the first upper channel pattern CH1_U are exposed by the first gate trench 120t. The second lower channel pattern CH2_B and the second upper channel pattern CH2_U are exposed by the second gate trench 220t.

Subsequently, the first gate insulating layer 130 is formed along the sidewall and the bottom surface of the first gate trench 120t. The first gate insulating layer 130 is formed along the circumference of the first lower sheet pattern NS1_B, the circumference of the first upper sheet pattern NS1_U, and the circumference of the first dummy sheet pattern NS1_D. The second gate insulating layer 230 is formed along the sidewall and the bottom surfaces of the second gate trench 220t. The second gate insulating layer 230 is formed along the circumference of the second lower sheet pattern NS2_B, the circumference of the second upper sheet pattern NS2_U, and the circumference of the second dummy sheet pattern NS2_D. The first gate insulating layer 130 and the second gate insulating layer 230 may extend along the upper surface of the interlayer insulating layer 190.

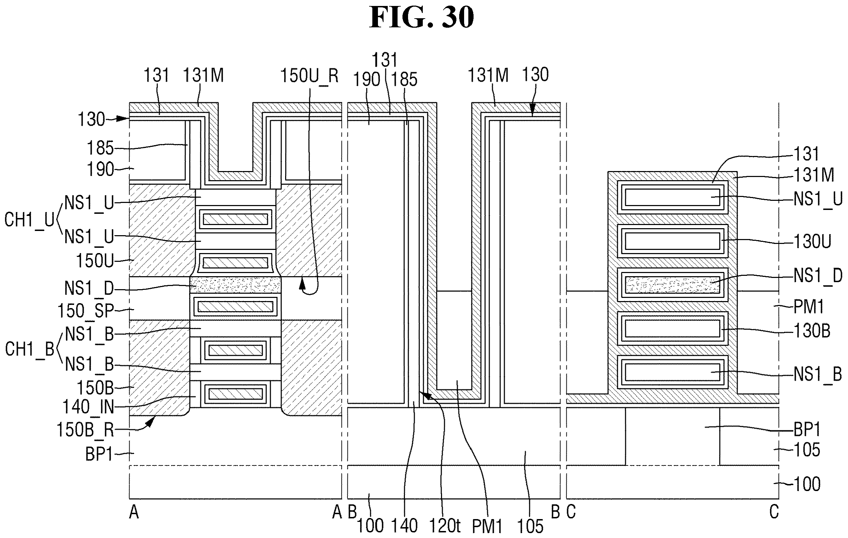

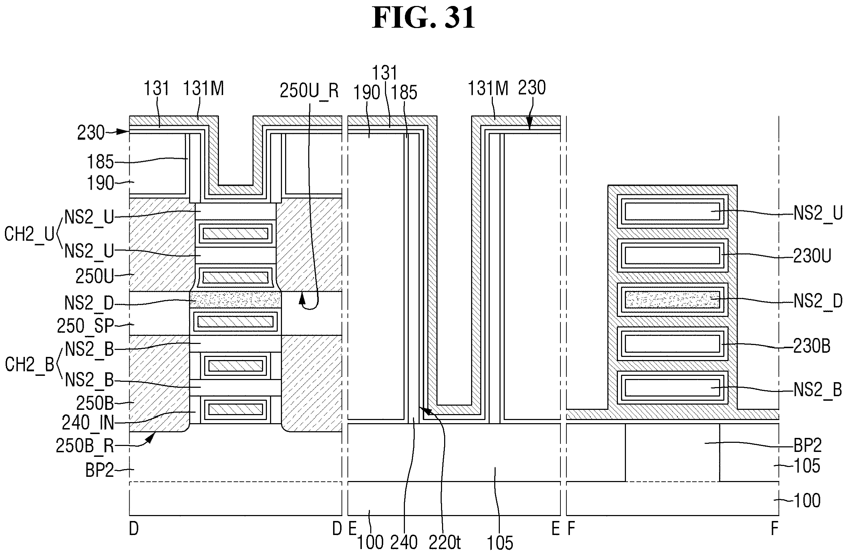

Referring to FIGS. 30 and 31, a first dipole layer 131 may be formed on the first gate insulating layer 130 and the second gate insulating layer 230.

The first dipole layer 131 may be formed along the profile of the first gate insulating layer 130 and the profile of the second gate insulating layer 230. The first dipole layer 131 may include, for example, one of lanthanum oxide (LaO), zirconium oxide (ZrO), or aluminum oxide (AlO), but is not limited thereto.

A blocking layer 131M may be formed on the first dipole layer 131. The blocking layer 131M may fill a space between the sheet patterns NS1_B, NS1_D, NS1_U, NS2_B, NS2_D, and NS2_U. The blocking layer 131M may surround the sheet patterns NS1_B, NS1_D, NS1_U, NS2_B, NS2_D, and NS2_U. The blocking layer 131M may include, for example, titanium nitride (TiN), but is not limited thereto.

A first patterning mask PM1 may be formed on the blocking layer 131M. The first patterning mask PM1 may expose the blocking layer 131M surrounding the first upper sheet pattern NS1_U. The first patterning mask PM1 may expose the blocking layer 131M surrounding the second lower sheet pattern NS2_B, the second dummy sheet pattern NS2_D, and the second upper sheet pattern NS2_U.

Referring to FIGS. 30 to 32, the first dipole layer 131 and the blocking layer 131M exposed by the first patterning mask PM1 are removed.

The first dipole layer 131 and the blocking layer 131M surrounding the first upper sheet pattern NS1_U are removed. The first dipole layer 131 and the blocking layer 131M surrounding the second lower sheet pattern NS2_B, the second dummy sheet pattern NS2_D, and the second upper sheet pattern NS2_U are removed.

Accordingly, the blocking layer 131M and the first dipole layer 131 surrounding the first lower sheet pattern NS1_B are left.

The first patterning mask PM1 is removed.

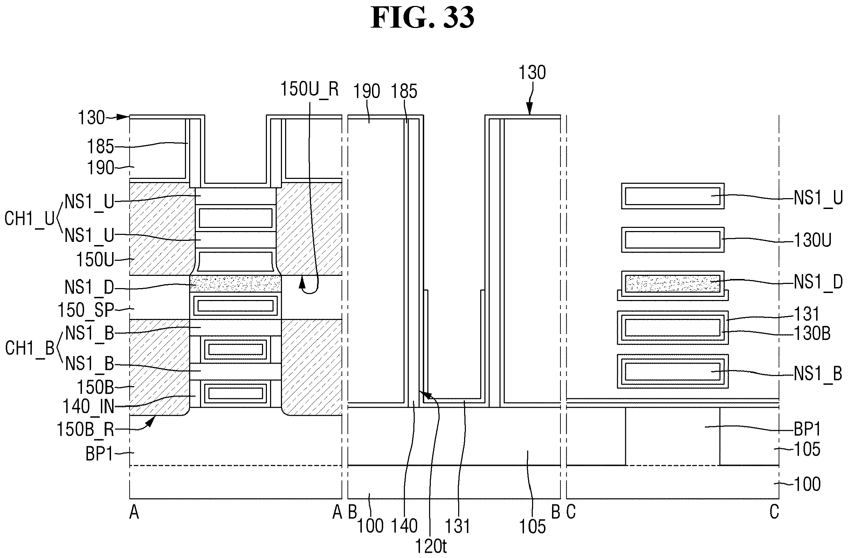

Referring to FIG. 33, the blocking layer 131M surrounding the first lower sheet pattern NS1_B may be removed.

The first dipole layer 131 surrounding the first lower sheet pattern NS1_B is left.

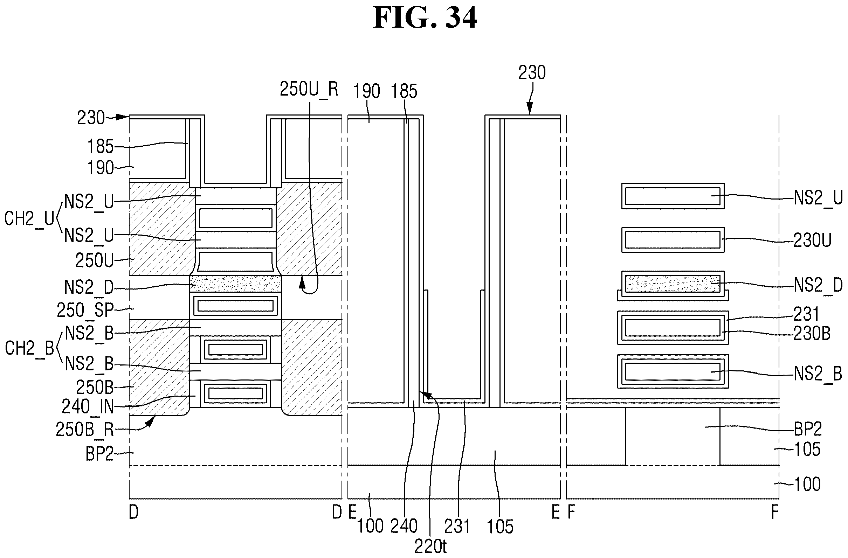

Referring to FIG. 34, a second dipole layer 231 surrounding the second lower sheet pattern NS2_B is formed.

The second dipole layer 231 may include, for example, one of lanthanum oxide (LaO), zirconium oxide (ZrO), or aluminum oxide (AlO), but is not limited thereto. The second dipole layer 231 includes a material different from that of the first dipole layer 131.

Through the fabrication method described above using FIGS. 30 to 33, the second dipole layer 231 may be formed.

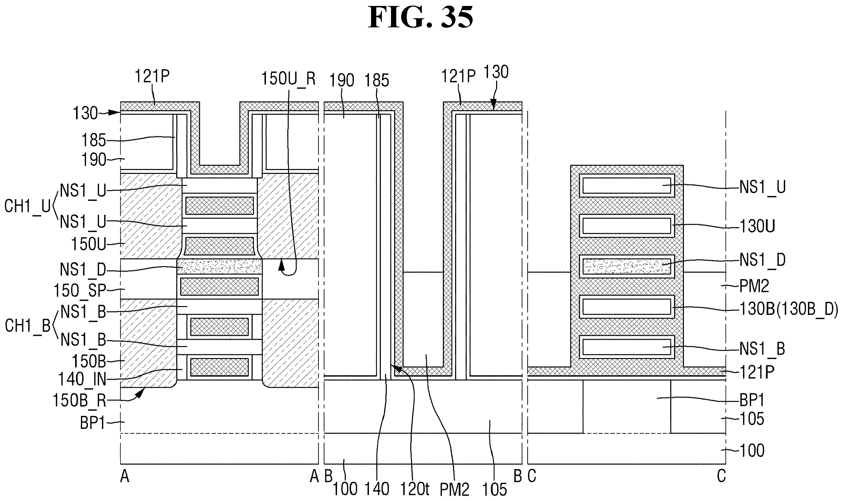

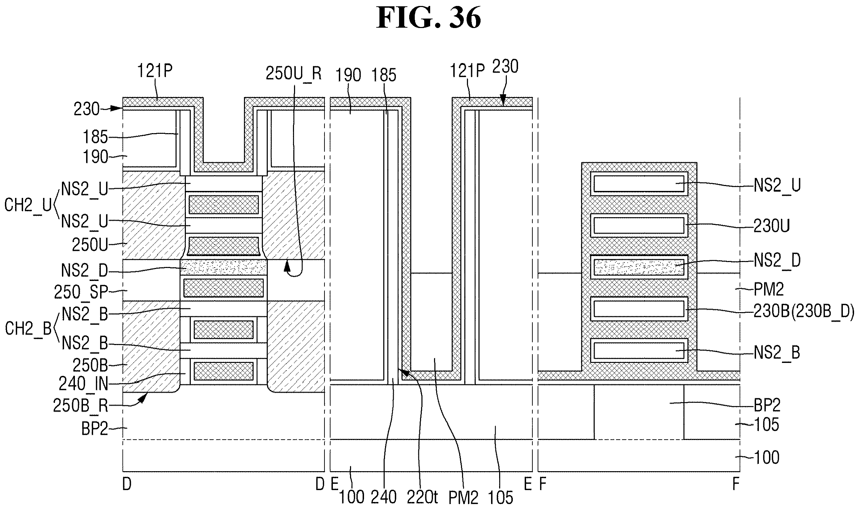

Referring to FIGS. 35 and 36, a pre-lower conductive liner layer 121P is formed on the first gate insulating layer 130 and the second gate insulating layer 230.

The pre-lower conductive liner layer 121P may fill a space between the sheet patterns NS1_B, NS1_D, NS1_U, NS2_B, NS2_D, and NS2_U. The pre-lower conductive liner layer 121P may surround the sheet patterns NS1_B, NS1_D, NS1_U, NS2_B, NS2_D, and NS2_U. The pre-lower conductive liner layer 121P may extend along the upper surface of the interlayer insulating layer 190.

Subsequently, a second patterning mask PM2 may be formed on the pre-lower conductive liner layer 121P. The second patterning mask PM2 exposes the pre-lower conductive liner layer 121P surrounding the first upper sheet pattern NS1_U and the second upper sheet pattern NS2_U.

Before the pre-lower conductive liner layer 121P is formed, a heat treatment process may be performed. Through the heat treatment process, a lower doping material of the first dipole layer (131 of FIG. 33) and the second dipole layer (231 of FIG. 34) may be diffused into the first gate insulating layer 130 and the second gate insulating layer 230. Accordingly, the first lower gate insulating layer 130B doped with the first lower doping material is formed. The second lower gate insulating layer 230B doped with the second lower doping material is formed. That is, the first lower doping gate insulating layer 130B_D and the second lower doping gate insulating layer 230B_D may be formed.

Referring to FIGS. 35 to 38, the pre-lower conductive liner layer 121P exposed by the second patterning mask PM2 is removed to form the first lower conductive liner layer 121B and the second lower conductive liner layer 221B.

The first lower conductive liner layer 121B defines the first lower liner trench 121B_t. The first lower conductive liner layer 121B surrounds the first lower channel pattern CH1_B. With respect to the upper surface of the field insulating layer 105, the uppermost portion of the first lower conductive liner layer 121B is lower than the bottom surface of the first upper channel pattern CH1_U.

The second lower conductive liner layer 221B defines the second lower liner trench 221B_t. The second lower conductive liner layer 221B surrounds the second lower channel pattern CH2_B. With respect to the upper surface of the field insulating layer 105, the uppermost portion of the second lower conductive liner layer 221B is lower than the bottom surface of the second upper channel pattern CH2_U.

The second patterning mask PM2 is removed.

While the first lower conductive liner layer 121B and the second lower conductive liner layer 221B are being formed, a residue 121P_R of the pre-lower conductive liner layer may be formed. The residue 121P_R of the pre-lower conductive liner layer may be formed between the first dummy sheet pattern NS1_D and the first upper sheet pattern NS1_U and between the adjacent first upper sheet patterns NS1_U. Further, the residue 121P_R of the pre-lower conductive liner layer may be formed between the second dummy sheet pattern NS2_D and the second upper sheet pattern NS2_U and between the adjacent second upper sheet patterns NS2_U.

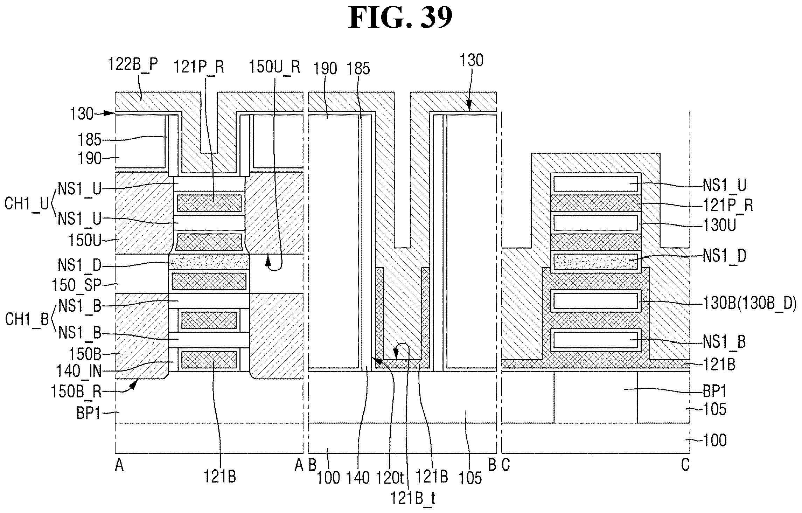

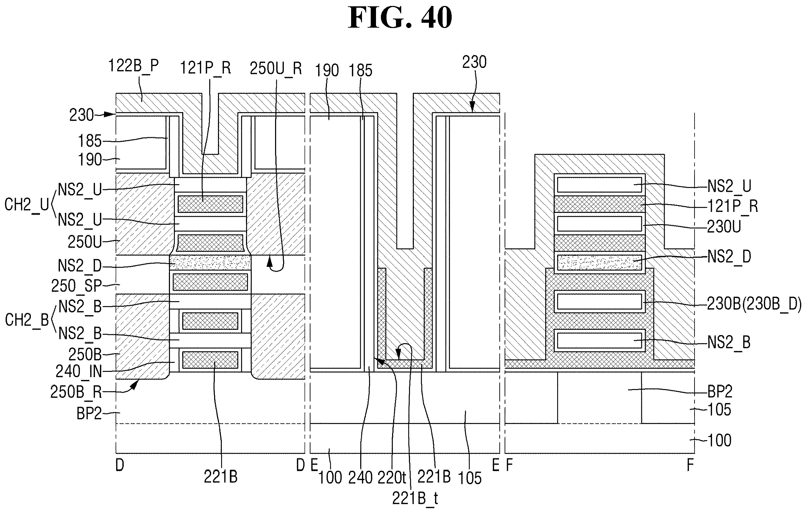

Referring to FIGS. 39 and 40, a pre-lower filling layer 122B_P may be formed on the first lower conductive liner layer 121B and the second lower conductive liner layer 221B.

The pre-lower filling layer 122B_P fills the first lower liner trench 121B_t and the second lower liner trench 221B_t entirely.

The pre-lower filling layer 122B_P does not entirely fill the first gate trench 120t defined above the uppermost part of the first lower conductive liner layer 121B. Further, the pre-lower filling layer 122B_P does not entirely fill the second gate trench 220t defined above the uppermost portion of the second lower conductive liner layer 221B. Above the uppermost portion of the first lower conductive liner layer 121B and the uppermost portion of the second lower conductive liner layer 221B, the pre-lower filling layer 122B_P may be formed in a liner shape.

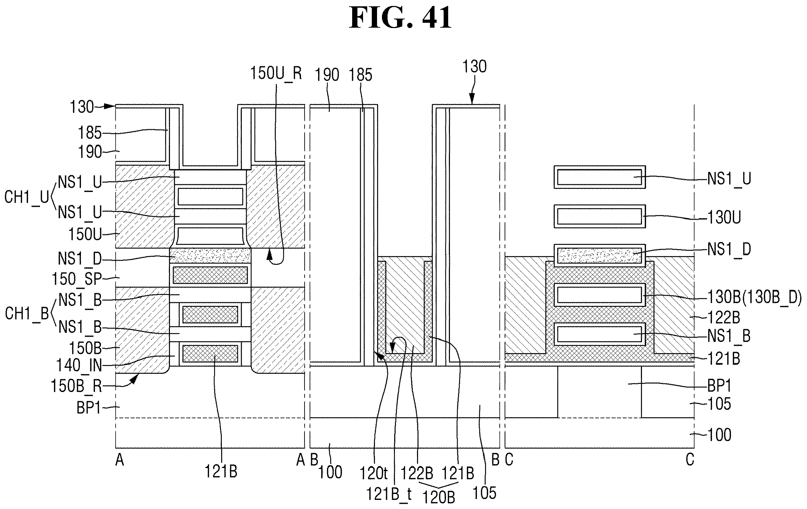

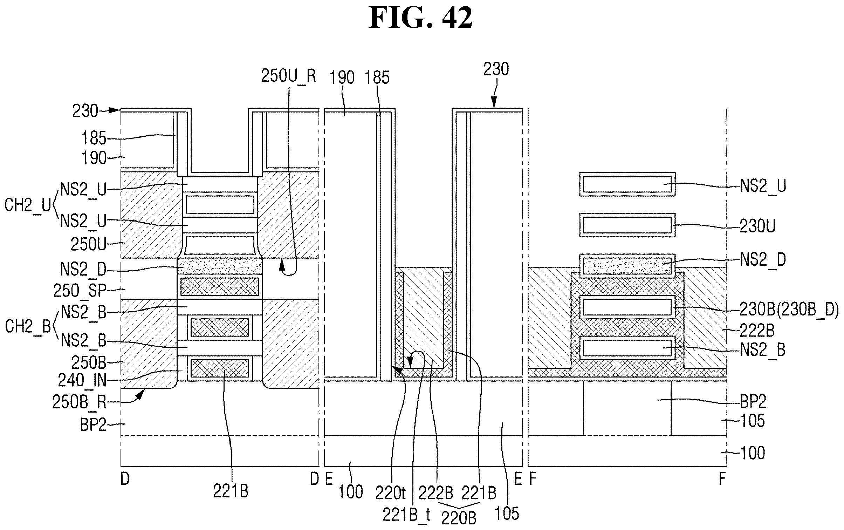

Referring to FIGS. 41 and 42, the first lower filling layer 122B is formed on the first lower conductive liner layer 121B. The first lower filling layer 122B fills the first lower liner trench 121B_t. Accordingly, the first lower gate electrode 120B is formed.

The second lower filling layer 222B is formed on the second lower conductive liner layer 221B. The second lower filling layer 222B fills the second lower liner trench 221B_t. Accordingly, the second lower gate electrode 220B is formed.

For example, through an etch-back process, the pre-lower filling layer 122B_P formed above the uppermost portion of the first lower conductive liner layer 121B and the uppermost portion of the second lower conductive liner layer 221B may be removed. Through such processes, the first lower filling layer 122B and the second lower filling layer 222B are simultaneously formed.

The entire upper surface of the first lower gate electrode 120B is positioned between the upper surface of the first lower channel pattern CH1_B and the bottom surface of the first upper channel pattern CH1_U. The entire upper surface of the second lower gate electrode 220B is positioned between the upper surface of the second lower channel pattern CH2_B and the bottom surface of the second upper channel pattern CH2_U.

After the first lower filling layer 122B and the second lower filling layer 222B are formed, the residue 121P_R of the pre-lower conductive liner layer is removed.

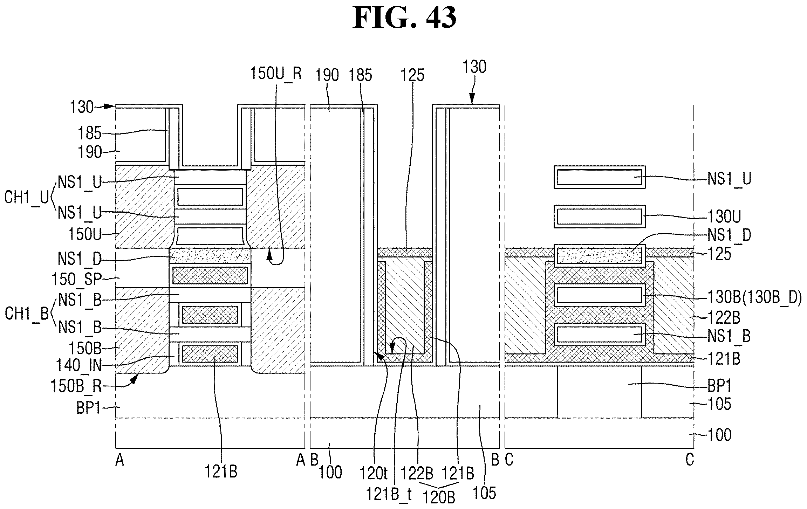

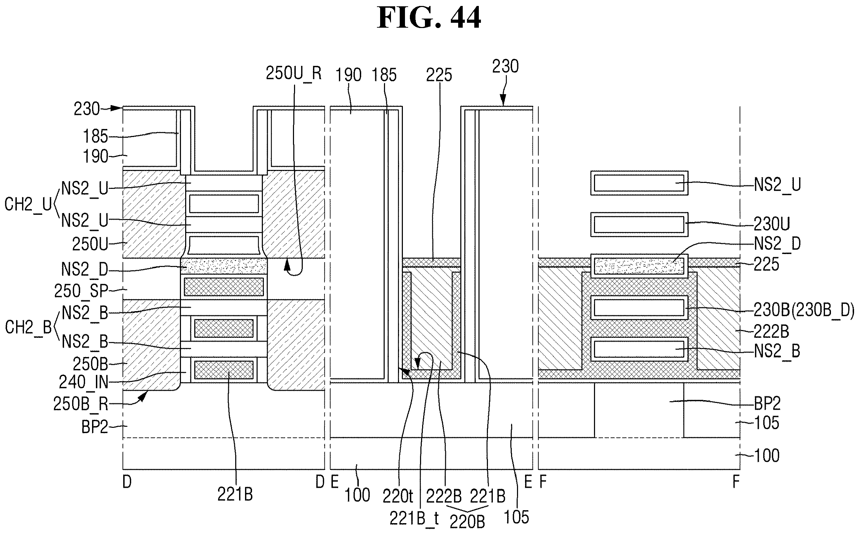

Referring to FIGS. 43 and 44, the first insertion pattern 125 is formed on the upper surface of the first lower filling layer 122B. The first insertion pattern 125 is formed along the upper surface of the first lower gate electrode 120B.

The second insertion pattern 225 is formed on the upper surface of the second lower filling layer 222B. The second insertion pattern 225 is formed along the upper surface of the second lower gate electrode 220B. The second insertion pattern 225 may be formed simultaneously with the first insertion pattern 125.

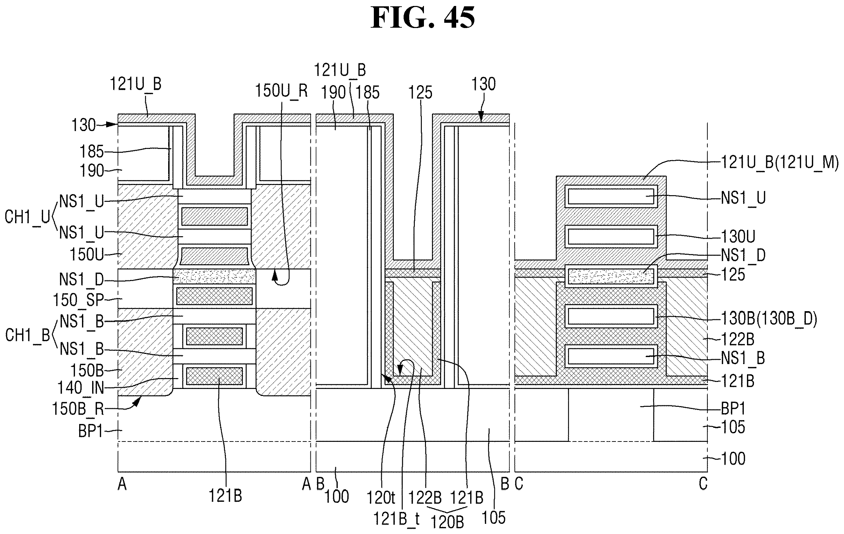

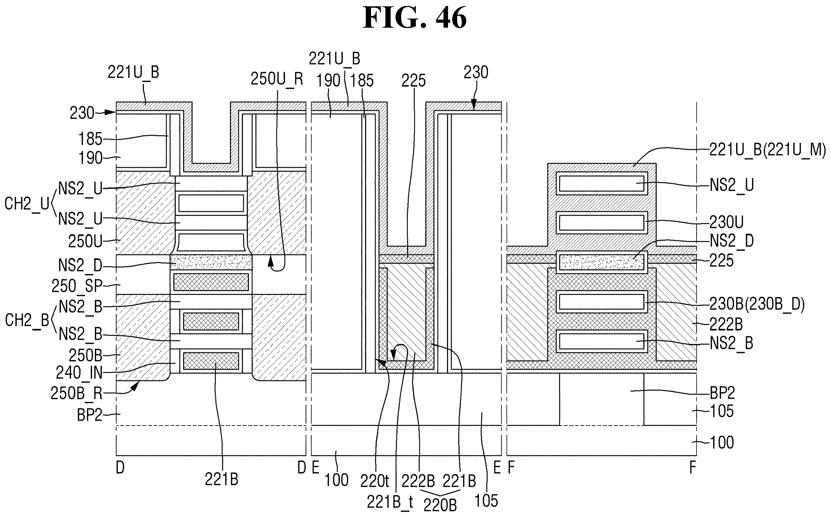

Referring to FIGS. 45 and 46, the lower layer 121U_B of the first upper conductive liner layer may be formed on the first insertion pattern 125. The lower layer 121U_B of the first upper conductive liner layer may be formed along the sidewall of the first gate trench 120t and the upper surface of the interlayer insulating layer 190.

Subsequently, the lower layer 221U_B of the second upper conductive liner layer may be formed on the second insertion pattern 225. The lower layer 221U_B of the second upper conductive liner layer may be formed along the sidewall of the second gate trench 220t and the upper surface of the interlayer insulating layer 190.

The lower layer 121U_B of the first upper conductive liner layer may include a first upper work function layer 121U_M. The lower layer 221U_B of the second upper conductive liner layer may include a second upper work function layer 221U_M different from the first upper work function layer 121U_M.

Subsequently, referring to FIGS. 2 and 3, the lower layer 121U_B of the first upper conductive liner layer and the lower layer 221U_B of the second upper conductive liner layer on the upper surface of the interlayer insulating layer 190 are removed. In addition, a part of the lower layer 121U_B of the first upper conductive liner layer on the sidewall of the first gate trench 120t may be removed. A part of the lower layer 221U_B of the second upper conductive liner layer on the sidewall of the second gate trench 220t may be removed.

Thereafter, the upper layer 121U_U of the first upper conductive liner layer and the first upper filling layer 122U are formed on the lower layer 121U_B of the first upper conductive liner layer. Accordingly, the first upper gate electrode 120U is formed.

Also, the upper layer 221U_U of the second upper conductive liner layer and the second upper filling layer 222U are formed on the lower layer 221U_B of the second upper conductive liner layer. Accordingly, the second upper gate electrode 220U is formed.

In concluding the detailed description, those skilled in the art will appreciate that many variations and modifications may be made to the disclosed example embodiments without substantially departing from the principles of the present inventive concepts. Therefore, the disclosed example embodiments of the inventive concepts are used in a generic and descriptive sense only and not for purposes of limitation.

## Claims

1. A semiconductor device comprising:
a lower pattern extending in a first direction;
a gate electrode on the lower pattern and extending in a second direction,;
a lower channel pattern on the lower pattern and comprising at least one lower sheet pattern; and
an upper channel pattern on the lower channel pattern and comprising at least one upper sheet pattern,
wherein the upper channel pattern is spaced apart from the lower channel pattern in a third direction,
the gate electrode comprises a lower gate electrode through which the lower sheet pattern passes and an upper gate electrode through which the upper sheet pattern passes,
the lower gate electrode comprises a lower conductive liner layer defining a lower liner trench and a lower filling layer filling the lower liner trench, and
an entire bottom surface of the upper gate electrode is higher than an upper surface of the lower gate electrode.

2. The semiconductor device of claim 1, wherein
the upper gate electrode comprises an upper conductive liner layer defining an upper liner trench and an upper conductive filling layer filling the upper liner trench, and
a bottom surface of the upper gate electrode is defined by the upper conductive liner layer.

3. The semiconductor device of claim 1 or 2, wherein
the gate electrode further comprises an insertion pattern extending along the upper surface of the lower gate electrode, and
the insertion pattern has one of a conductive material or an insulating material.

4. The semiconductor device of any preceding claim, further comprising:
a dummy sheet pattern between the lower channel pattern and the upper channel pattern,
wherein the dummy sheet pattern includes an insulating material.

5. A semiconductor device comprising:
a first lower pattern extending in a first direction;
a second lower pattern extending in the first direction;
a first gate electrode on the first lower pattern and extending in a second direction;
a second gate electrode on the second lower pattern and extending in the second direction;
a first lower channel pattern on the first lower pattern and comprising at least one first lower sheet pattern;
a first upper channel pattern on the first lower channel pattern and comprising at least one first upper sheet pattern;
a second lower channel pattern on the second lower pattern and comprising at least one second lower sheet pattern;
a second upper channel pattern on the second lower channel pattern and comprising at least one second upper sheet pattern;
a first gate insulating layer between the first lower sheet pattern and the first gate electrode and between the first upper sheet pattern and the first gate electrode; and
a second gate insulating layer disposed between the second lower sheet pattern and the second gate electrode and between the second upper sheet pattern and the second gate electrode,
wherein the first gate electrode comprises a first lower gate electrode through which the first lower sheet pattern passes, a first upper gate electrode through which the first upper sheet pattern passes, and a first insertion pattern between the first lower gate electrode and the first upper gate electrode,
the second gate electrode comprises a second lower gate electrode through which the second lower sheet pattern passes, a second upper gate electrode through which the second upper sheet pattern passes, and a second insertion pattern between the second lower gate electrode and the second upper gate electrode,
the first insertion pattern is between an upper surface of the first lower channel pattern and a bottom surface of the first upper channel pattern,
the second insertion pattern is between an upper surface of the second lower channel pattern and a bottom surface of the second upper channel pattern, and
the first insertion pattern includes a same material as the second insertion pattern.

6. The semiconductor device of claim 5, wherein
the first gate insulating layer includes a same material as the second gate insulating layer,
the first gate insulating layer surrounding the first lower sheet pattern includes a first lower doping material, and
the second gate insulating layer surrounding the second lower sheet pattern includes a second lower doping material different from the first lower doping material.

7. The semiconductor device of claim 6, wherein
the first upper gate electrode comprises a first upper conductive liner layer surrounding the first upper sheet pattern,
the second upper gate electrode comprises a second upper conductive liner layer surrounding the second upper sheet pattern, and
the first upper conductive liner layer has a material different from that of the second upper conductive liner layer.

8. The semiconductor device of claim 6, wherein
the first upper gate electrode comprises a first upper conductive liner layer surrounding the first upper sheet pattern,
the second upper gate electrode comprises a second upper conductive liner layer surrounding the second upper sheet pattern,
the first upper conductive liner layer includes a same material as the second upper conductive liner layer, and
a thickness of the first upper conductive liner layer is different from a thickness of the second upper conductive liner layer.

9. The semiconductor device of any one of claims 6, 7 or 8, wherein
the first gate insulating layer surrounding the first upper sheet pattern includes a first upper doping material, and
the second gate insulating layer surrounding the second upper sheet pattern includes a second upper doping material different from the first upper doping material.

10. The semiconductor device of claim 5, wherein
the first lower gate electrode comprises a first lower conductive liner layer surrounding the first lower sheet pattern,
the second lower gate electrode comprises a second lower conductive liner layer surrounding the second lower sheet pattern,
the first lower conductive liner layer includes a same material as the second lower conductive liner layer, and
a thickness of the first lower conductive liner layer is different from a thickness of the second lower conductive liner layer.

11. The semiconductor device of claim 10, wherein
the first upper gate electrode comprises a first upper conductive liner layer surrounding the first upper sheet pattern,
the second upper gate electrode comprises a second upper conductive liner layer surrounding the second upper sheet pattern, and
the first upper conductive liner layer includes a material different from that of the second upper conductive liner layer.

12. The semiconductor device of claim 10, wherein
the first upper gate electrode comprises a first upper conductive liner layer surrounding the first upper sheet pattern,
the second upper gate electrode comprises a second upper conductive liner layer surrounding the second upper sheet pattern,
the first upper conductive liner layer includes a same material as the second upper conductive liner layer, and
a thickness of the first upper conductive liner layer is different from a thickness of the second upper conductive liner layer.

13. The semiconductor device of any one of claims 10, 11 or 12, wherein
the first gate insulating layer surrounding the first upper sheet pattern includes a first upper doping material, and
the second gate insulating layer surrounding the second upper sheet pattern includes a second upper doping material different from the first upper doping material.

14. The semiconductor device of claim 5, wherein
the first lower gate electrode comprises a first lower conductive liner layer surrounding the first lower sheet pattern,
the second lower gate electrode comprises a second lower conductive liner layer surrounding the second lower sheet pattern, and
the first lower conductive liner layer includes a material different from that of the second lower conductive liner layer.

15. A semiconductor device comprising:
a first lower pattern extending in a first direction;
a second lower pattern extending in the first direction;
a first gate electrode on the first lower pattern and extending in a second direction;
a second gate electrode on the second lower pattern and extending in the second direction;
a first lower channel pattern on the first lower pattern and comprising at least one first lower sheet pattern;
a first upper channel pattern on the first lower channel pattern and comprising at least one first upper sheet pattern;
a second lower channel pattern on the second lower pattern and comprising at least one second lower sheet pattern;
a second upper channel pattern on the second lower channel pattern and comprising at least one second upper sheet pattern;
a first gate insulating layer between the first lower sheet pattern and the first gate electrode and between the first upper sheet pattern and the first gate electrode; and
a second gate insulating layer between the second lower sheet pattern and the second gate electrode and between the second upper sheet pattern and the second gate electrode,
wherein the first gate electrode comprises a first lower gate electrode through which the first lower sheet pattern passes, and a first upper gate electrode through which the first upper sheet pattern passes,
the second gate electrode comprises a second lower gate electrode through which the second lower sheet pattern passes, and a second upper gate electrode through which the second upper sheet pattern passes,
the first lower gate electrode comprises a first lower conductive liner layer defining a first lower liner trench and a first lower filling layer filling the first lower liner trench,
the second lower gate electrode comprises a second lower conductive liner layer defining a second lower liner trench and a second lower filling layer filling the second lower liner trench,
an entire bottom surface of the first upper gate electrode is between an upper surface of the first lower channel pattern and a bottom surface of the first upper channel pattern,
an entire bottom surface of the second upper gate electrode is between an upper surface of the second lower channel pattern and a bottom surface of the second upper channel pattern,
the first lower conductive liner layer includes a same material as the second lower conductive liner layer,
the first gate insulating layer includes a same material as the second gate insulating layer,
the first gate insulating layer surrounding the first lower sheet pattern includes a first lower doping material, and
the second gate insulating layer surrounding the second lower sheet pattern includes a second lower doping material different from the first lower doping material.
